# EUROPEAN PATENT APPLICATION

(11) **EP 4 239 883 A1**
(43) Date of publication of application: **06.09.2023**
(21) Application number: 21885863.7
(22) Date of filing: 07.10.2021
(51) Int. Cl.: H03K 3/037, H03K 3/356

(54) **COMBINED LOGIC CIRCUIT**

(30) Priority: 30.10.2020 JP 2020183227
(71) Applicant: Sony Semiconductor Solutions Corporation, Atsugi-shi, Kanagawa 243-0014 (JP)
(72) Inventor: TANAKA, Yoshinori, Atsugi-shi, Kanagawa 243-0021 (JP); KAWAKAMI, Atsushi, Atsugi-shi, Kanagawa 243-0021 (JP)
(74) Representative: MFG Patentanwälte Meyer-Wildhagen Meggle-Freund Gerhard PartG mbB
(86) International application number: PCT/JP2021/037228
(87) International publication number: WO 2022/091744

(57) **Abstract**

A combined logic circuit according to an aspect of the present disclosure includes a latch circuit and an inverter circuit. The latch circuit includes a single phase clocking circuit that includes a NAND circuit. The inverter circuit inverts an output signal of the latch circuit.

## Description

### Technical Field

The present disclosure relates to a combined logic circuit.

### Background Art

In an existing typical clock gating cell (Clock Gating Cell), an internal clock node for a latch operation in a cell toggles in accordance with toggling of an input clock also when the clock is shut off (at the time of Disable), which dissipates electric power. A measure to reduce electric power dissipation while the clock is shut off is disclosed, for example, in NPTL 1 below.

### Citation List

### Non-Patent Literature

NPTL 1: https://www.edn.com/design/integrated-circuit-design/4434410/Recursive-clock-gating--Performance-implications

### Summary of the Invention

Incidentally, NPTL 1 described above has an issue that the circuit size increases because a control circuit that controls the toggling of the node described above is added to a clock gating cell. Similar issues can arise in a combined logic circuit such as a flip-flop circuit including a latch circuit. It is therefore desirable to provide a combined logic circuit that makes it possible to suppress an increase in circuit size.

A combined logic circuit according to an aspect of the present disclosure includes a latch circuit and an inverter circuit. The latch circuit includes a single phase clocking circuit that includes a NAND circuit. The inverter circuit inverts an output signal of the latch circuit.

In the combined logic circuit according to the aspect of the present disclosure, the latch circuit includes a single phase clocking circuit including the NAND circuit. Using the single phase clocking circuit that does not use an inverted signal of a clock as described above makes it possible to suppress electric power dissipation corresponding to toggling of the clock. In addition, this combined logic circuit is provided with the inverter circuit that inverts the output signal of the latch circuit. This allows for forming an AND circuit with the NAND circuit in the latch circuit and the inverter circuit. It is therefore possible to suppress the circuit size as compared with a case where the AND circuit is provided separately from the latch circuit.

### Brief Description of Drawings

[FIG. 1] FIG. 1 is a diagram illustrating an example of functional blocks of a clock gating cell according to a first embodiment of the present disclosure.
[FIG. 2] FIG. 2 is a diagram illustrating state transition of the clock gating cell of FIG. 1.
[FIG. 3] FIG. 3 is a diagram illustrating an example of a circuit configuration of the clock gating cell of FIG. 1.
[FIG. 4] FIG. 4 is a diagram illustrating an example of functional blocks of a clock gating cell according to a comparative example.
[FIG. 5] FIG. 5 is a diagram illustrating a modification of the circuit configuration of the clock gating cell of FIG. 1.
[FIG. 6] FIG. 6 is a diagram illustrating a modification of the circuit configuration of the clock gating cell of FIG. 1.
[FIG. 7] FIG. 7 is a diagram illustrating a modification of the functional blocks of the clock gating cell of FIG. 1.
[FIG. 8] FIG. 8 is a diagram illustrating state transition of a clock gating cell of FIG. 7.
[FIG. 9] FIG. 9 is a diagram illustrating a modification of a circuit configuration of the clock gating cell of FIG. 7.
[FIG. 10] FIG. 10 is a diagram illustrating a modification of the circuit configuration of the clock gating cell of FIG. 7.
[FIG. 11] FIG. 11 is a diagram illustrating a modification of the circuit configuration of the clock gating cell of FIG. 7.
[FIG. 12A] FIG. 12A is a diagram illustrating a modification of the functional blocks of the clock gating cell of FIG. 1.
[FIG. 12B] FIG. 12B is a diagram illustrating a modification of the functional blocks of the clock gating cell of FIG. 7.
[FIG. 13] FIG. 13 is a diagram illustrating an example of a circuit configuration of a flip-flop circuit according to a second embodiment of the present disclosure.
[FIG. 14] FIG. 14 is a diagram illustrating a modification of the circuit configuration of the flip-flop circuit of FIG. 13.
[FIG. 15] FIG. 15 is a diagram illustrating a modification of the circuit configuration of the flip-flop circuit of FIG. 13.
[FIG. 16] FIG. 16 is a diagram illustrating a modification of the circuit configuration of the flip-flop circuit of FIG. 13.
[FIG. 17] FIG. 17 is a diagram illustrating a modification of the circuit configuration of the flip-flop circuit of FIG. 13.
[FIG. 18] FIG. 18 is a diagram illustrating a modification of the circuit configuration of the flip-flop circuit of FIG. 13.
[FIG. 19] FIG. 19 is a diagram illustrating a modification of the circuit configuration of the flip-flop circuit of FIG. 13.
[FIG. 20] FIG. 20 is a diagram illustrating a modification of the circuit configuration of the flip-flop circuit of FIG. 13.
[FIG. 21] FIG. 21 is a diagram illustrating a modification of the circuit configuration of the flip-flop circuit of FIG. 13.
[FIG. 22] FIG. 22 is a diagram illustrating a modification of the circuit configuration of the flip-flop circuit of FIG. 13.
[FIG. 23] FIG. 23 is a diagram illustrating a modification of the circuit configuration of the flip-flop circuit of FIG. 13.
[FIG. 24] FIG. 24 is a diagram illustrating a modification of the circuit configuration of the flip-flop circuit of FIG. 13.
[FIG. 25] FIG. 25 is a diagram illustrating an example of functional blocks of a clock gating cell according to a third embodiment of the present disclosure.
[FIG. 26] FIG. 26 is a diagram illustrating an example of a circuit configuration of a latch section of FIG. 25.
[FIG. 27] FIG. 27 is a diagram illustrating a modification of the circuit configuration of the latch section of FIG. 25.
[FIG. 28] FIG. 28 is a diagram illustrating a modification of the circuit configuration of the latch section of FIG. 25.
[FIG. 29] FIG. 29 is a waveform diagram of a clock gating cell including the latch section of FIG. 27.
[FIG. 30] FIG. 30 is a waveform diagram of a clock gating cell including the latch section of FIG. 28.
[FIG. 31] FIG. 31 is a waveform diagram of a clock gating cell including the latch section of FIG. 26.
[FIG. 32] FIG. 32 is a diagram illustrating a circuit configuration example of a clock gating cell according to a comparative example.
[FIG. 33] FIG. 33 is a diagram illustrating a circuit configuration example of a clock gating cell according to a comparative example.
[FIG. 34] FIG. 34 is a diagram illustrating a modification of a circuit configuration of an enable generation section of FIG. 25.
[FIG. 35] FIG. 35 is a diagram illustrating a modification of a circuit configuration of the latch section of FIG. 25.
[FIG. 36] FIG. 36 is a diagram illustrating a modification of the circuit configuration of the enable generation section of FIG. 25.

### Modes for Carrying Out the Invention

In the following, modes for carrying out the present disclosure are described in detail with reference to the drawings. It is to be noted that in the present description and the drawings, components having substantially the same functional configurations are denoted by the same reference signs to omit redundant description.

### <1. First Embodiment>

### [Configuration]

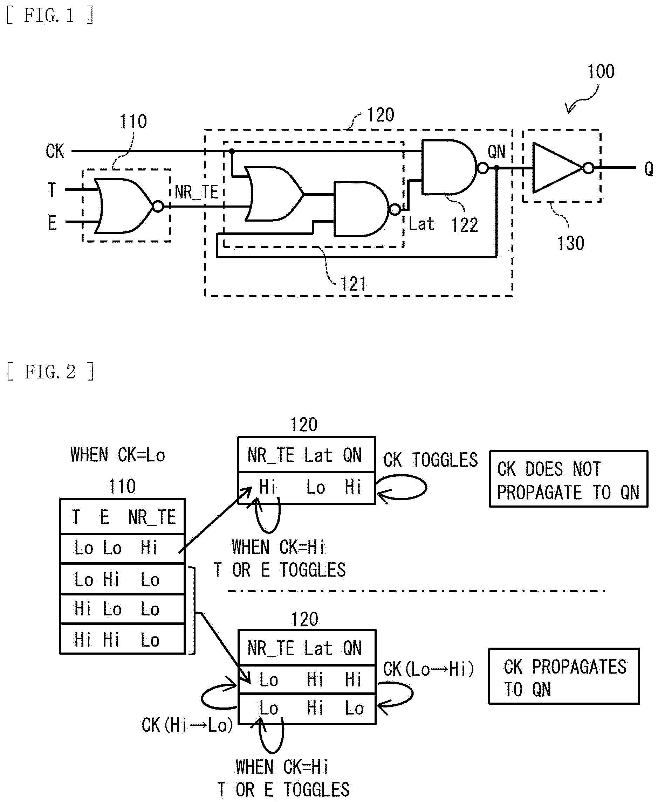

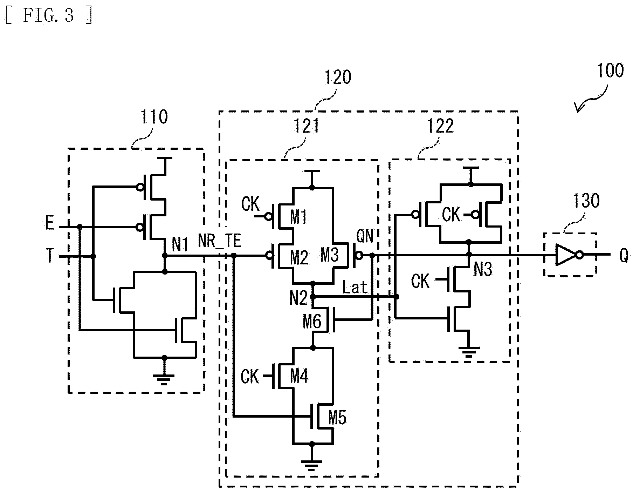

FIG. 1 illustrates an example of functional blocks of a clock gating cell 100 according to a first embodiment of the present disclosure. FIG. 2 illustrates state transition of the clock gating cell 100. FIG. 3 illustrates an example of a circuit configuration of the clock gating cell 100.

The clock gating cell 100 is, for example, a circuit for stopping a clock supplied to a register with no change in data and suppressing unnecessary electric power dissipation in the register. The clock gating cell 100 includes an enable generation section 110, a latch section 120, and an output section 130. The clock gating cell 100 receives a clock signal CK, an enable signal E for system, and an enable signal T for testing. The clock gating cell 100 outputs an output signal Q. The clock signal CK is a signal for controlling an operation of the clock gating cell 100. The output signal Q is, for example, a signal supplied to the register or the like.

The enable generation section 110 includes, for example, a two-input and one-output NOR circuit, as illustrated in FIG. 1. This NOR circuit receives the enable signals E and T as input signals. This NOR circuit outputs an enable signal NR_TE. The enable generation section 110 may include a NOR circuit having three or more inputs in place of the two-input and one-output NOR circuit.

The two-input and one-output NOR circuit is configured to include, for example, four transistors. The two-input and one-output NOR circuit is configured to include, for example, two PMOS transistors and two NMOS transistors, as illustrated in FIG. 3. The two PMOS transistors are coupled to each other in series. Aterminal that receives the enable signal E is coupled to the gate of one of the PMOS transistors, and a terminal that receives the enable signal T is coupled to the gate of another of the PMOS transistors. The two NMOS transistors are coupled in series to the two PMOS transistors. In addition, the two NMOS transistors are coupled to each other in parallel. The terminal that receives the enable signal E is coupled to the gate of one of the NMOS transistors, and the terminal that receives the enable signal T is coupled to the gate of another of the NMOS transistors. The source and drain terminal of the one of the two PMOS transistors and the source and drain terminals, of the two NMOS transistors, that are coupled to each other are coupled to a node N1. The source and drain terminal of the other of the two PMOS transistors is coupled to a constant voltage line, and the source and drain terminals of the two NMOS transistors that are not coupled to the node N1 are coupled to a ground line. The node N1 is coupled to the latch section 120.

In the two-input and one-output NOR circuit, the enable signal NR_TE is set to the high level Hi when both of the two input signals (the enable signals E and T) are at the low level Lo (Disable) (see FIG. 2). In addition, in the two-input and one-output NOR circuit, the enable signal NR_TE is set to the low level Lo when one or both of the input signals (the enable signal E, the enable signal T, or both) are set to the high level Hi (Enable) (see FIG. 2). That is, the enable signal NR_TE is set to the high level Hi only when both of the two input signals (the enable signals E and T) are at the low level Lo (Disable).

The latch section 120 is a latch circuit (a single phase clocking latch circuit) that includes a single phase clocking circuit including a NAND circuit. Here, the "single phase clocking latch circuit" refers to a latch circuit that does not require an inverted signal of the clock CK for a latch operation.

As illustrated in FIG. 1, the latch section 120 is configured to include, for example, an internal signal generation circuit 121 and a data holding circuit 122. The internal signal generation circuit 121 uses the clock signal CK and the enable signal NR_TE.

The internal signal generation circuit 121 outputs the low level Lo as an internal signal Lat when both of the two input signals (the enable signals E and T) are at the low level Lo (that is, when the enable signal NR_TE is at the high level Hi) (see FIG. 2). The internal signal generation circuit 121 outputs the high level Hi as the internal signal Lat when one or both of the input signals (the enable signal E, the enable signal T, or both) are at the high level Hi (see FIG. 2). The internal signal generation circuit 121 causes the clock signal CK to pass through as it is and supplies it to the data holding circuit 122. The data holding circuit 122 receives the clock signal CK and the internal signal Lat from the internal signal generation circuit 121.

That is, the latch section 120 includes a logic circuit that supplies the clock signal CK from an outside to one input node of the data holding circuit 122 (a two-input NAND circuit), and supplies the internal signal Lat at the low level Lo to another input node of the data holding circuit 122 (the two-input NAND circuit) when the enable signal NR_TE is set to the high level Hi while the clock signal is at the low level Lo.

When both of the two input signals (the enable signals E and T) are at the low level Lo, the data holding circuit 122 outputs the high level Hi as an output signal QN because the internal signal Lat remains at the low level Lo even if the clock signal CK toggles (see FIG. 2). That is, when both of the two input signals (the enable signals E and T) are at the low level Lo, the clock signal CK does not propagate to the output signal QN, and neither to the output signal Q of the output circuit 130.

In contrast, the data holding circuit 122 changes the output signal QN from the high level Hi to the low level Lo if the clock signal CK changes from the low level Lo to the high level Hi when one or both of the input signals (the enable signal E, the enable signal T, or both) are at the high level Hi (see FIG. 2). In addition, the data holding circuit 122 changes the output signal QN from the low level Lo to the high level Hi if the clock signal CK changes from the high level Hi to the low level Lo when one or both of the input signals (the enable signal E, the enable signal T, or both) are at the high level Hi (see FIG. 2). That is, when one or both of the input signals (the enable signal E, the enable signal T, or both) are at the high level Hi, the clock signal CK propagates to the output signal QN, and also to the output signal Q of the output circuit 130.

The internal signal generation circuit 121 includes, for example, a two-input and one-output OR circuit and a two-input and one-output NAND circuit, as illustrated in FIG. 1. The OR circuit receives the clock signal CK and the enable signal NR_TE. The NAND circuit receives an output signal of the OR circuit and the output signal QN of the data holding circuit 122. The internal signal Lat of the NAND circuit is supplied to the data holding circuit 122.

The internal signal generation circuit 121 is configured to include, for example, six transistors (M1 to M6), as illustrated in FIG. 3. The internal signal generation circuit 121 is configured to include, for example, three PMOS transistors (M1 to M3) and three NMOS transistors (M4 to M6). Two PMOS transistors (M1 and M2) out of the three PMOS transistors (M1 to M3) are coupled to each other in series. The remaining PMOS transistor (M3) is coupled in parallel to the two PMOS transistors (M1 and M2) that are coupled to each other in series. Two NMOS transistors (M4 and M5) out of the three NMOS transistors (M4 to M6) are coupled to each other in parallel. The remaining NMOS transistor (M6) is coupled in series to the two NMOS transistors (M4 and M5) that are coupled to each other in parallel.

The gate of the PMOS transistor (M1) is coupled to a terminal that receives the clock signal CK. The gate of the PMOS transistor (M2) is coupled to the node N1 (a terminal that outputs the enable signal NR_TE) of the enable generation section 110. The gate of the PMOS transistor (M3) is coupled to a node N3 of the data holding circuit 122. The gate of the NMOS transistor (M4) is coupled to a terminal that receives the clock signal CK. The gate of the NMOS transistor (M5) is coupled to the node N1 (the terminal that outputs the enable signal NR_TE) of the enable generation section 110. The gate of the NMOS transistor (M6) is coupled to the node N3 of the data holding circuit 122. The source and drain terminals, of the PMOS transistors (M2 and M3), that are coupled to each other, and the source and drain terminal, of the NMOS transistor (M4), that are not coupled to the two NMOS transistors (M5 and M6) are coupled to a node N2. The source and drain terminals, of the PMOS transistors (M1 and M3), that are coupled to each other are coupled to a constant voltage line. The source and drain terminals, of the NMOS transistors (M4 and M5), that are coupled to each other are coupled to a ground line.

The data holding circuit 122 includes, for example, two-input and one-output NAND circuit, as illustrated in FIG. 1. The NAND circuit receives the clock signal CK and the internal signal Lat of the internal signal generation circuit 121. The output signal QN of the NAND circuit is supplied to the internal signal generation circuit 121 and the output section 130. The output signal QN of the NAND circuit is supplied to the internal signal generation circuit 121 as one input signal of the NAND circuit in the internal signal generation circuit 121, and is supplied to the output section 130 as an input signal of the output section 130.

The data holding circuit 122 is configured to include, for example, four transistors, as illustrated in FIG. 3. The data holding circuit 122 is configured to include, for example, two PMOS transistors and two NMOS transistors. The two PMOS transistors are coupled to each other in parallel. The gate of one of the PMOS transistors is coupled to the node N2 of the internal signal generation circuit 121. The gate of another of the PMOS transistors is coupled to a terminal that receives the clock signal CK. The two NMOS transistors are coupled to each other in series. The gate of one of the NMOS transistors is coupled to a terminal that receives the clock signal CK. The gate of another of the NMOS transistors is coupled to the node N2 of the internal signal generation circuit 121. The source and drain terminal of the one of the two NMOS transistors and the source and drain terminals, of the two PMOS transistors, that are coupled to each other are coupled to the node N3. The source and drain terminal of the other of the two NMOS transistors is coupled to a ground line. The source and drain terminals, of the two PMOS transistors, that are not coupled to the node N3 are coupled to a constant voltage line.

The output circuit 130 is an inverter that inverts the output signal (the output signal QN) of the data holding circuit 122, and outputs an inverted signal of the output signal QN as the output signal Q. The inverter includes, for example, two transistors (a PMOS transistor and an NMOS transistor). In the clock gating cell 100, the NAND circuit of the data holding circuit 122 and the inverter of the output circuit 130 form an AND circuit. That is, in the clock gating cell 100, a circuit (the NAND circuit) of a portion of the latch section 120 also serves as a portion of the AND circuit provided on the stage after the latch section 120.

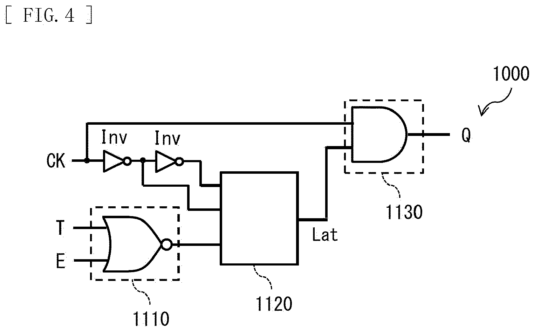

FIG. 4 illustrates an example of functional blocks of a clock gating cell 1000 according to a comparative example. The clock gating cell 1000 includes two inverters Inv, an enable generation section 1110, a latch section 1120, and an output section 1130. The two inverters Inv are coupled to each other in series, and generates a signal to be used for a latch control while inverting the clock signal CK supplied from an outside. The enable generation section 1110 generates an enable signal supplied to the latch section 1120. The enable generation section 1110 includes, for example, a NOR circuit. The latch section 1120 generates the internal signal Lat on the basis of an inverted signal obtained by inverting the clock signal CK by the inverter Inv, a signal obtained by inverting this inverted signal by the inverter Inv, and the enable signal supplied from the enable generation section 1110. The output section 1130 generates the output signal Q on the basis of the clock signal CK and the internal signal Lat. The output section 1130 includes, for example, an AND circuit. The AND circuit formed by the NAND circuit of the data holding circuit 122 and the inverter of the output circuit 130 is a logic circuit equivalent to the AND circuit of the output section 1130 according to the comparative example.

### [Effects]

In the present embodiment, the latch circuit 120 includes the single phase clocking circuit including the NAND circuit. Using the single phase clocking circuit that does not use the inverted signal of the clock signal CK as described above makes it possible to suppress electric power dissipation corresponding to the toggling of the clock signal CK. In addition, this combined logic circuit 100 is also provided with the inverter circuit (the output circuit 130) that inverts the output signal QN of the latch circuit 120. This makes it possible to form the AND circuit with the NAND circuit in the latch circuit 120 and the inverter circuit (the output circuit 130). It is therefore possible to suppress the circuit size, as compared with a case where the AND circuit is provided separately from the latch circuit 120.

In the present embodiment, the enable generation section 110 generates the control signal (the enable signal NR_TE) at the high level Hi when both of the enable signals E and T are at the low level Lo, and generates the control signal (the enable signal NR_TE) at the low level Lo when any of the enable signals E and T is at the high level Hi. Further, in the present embodiment, in the latch section 120, one input node of the data holding circuit 122 (the two-input NAND circuit) receives the clock signal CK from the outside, and another input node of the data holding circuit 122 (the two-input NAND circuit) receives the internal signal Lat at the low level Lo when the enable signal NR_TE is set to the high level Hi while the clock signal CK is at the low level Lo. In this case, even if the clock signal CK toggles, the output signal QN of the data holding circuit 122 (the two-input NAND circuit) remains at the high level Hi. That is, it goes without saying that the clock signal CK does not propagate to the output signal QN when both of the enable signals E and T are at the low level Lo. Further, regardless of how much the clock signal CK toggles, no node to be charged and discharged is present other than the gate terminal of the transistor to which the clock signal CK is coupled. Accordingly, it is possible to suppress electric power dissipation corresponding to the toggling of the clock signal CK when both of the enable signals E and T are at the low level Lo.

In addition, in the latch circuit 120 according to the present embodiment, for example, as illustrated in FIG. 3, in a case where the number of the PMOS transistors and the number of the NMOS transistors are equal to each other, it is possible to improve the balance of the circuit layout of the latch circuit 120.

### <2. Modifications of First Embodiment>

Next, a description is given of modifications of the clock gating cell 100 according to the first embodiment.

### [Modification A]

In the first embodiment, the transistors of the latch circuit 120 may be so adjusted that the output signal QN of the data holding circuit 122 transitions from the high level Hi to the low level Lo before the output (the internal signal Lat) of the internal signal generation circuit 121 transitions from the high level Hi to the low level Lo when the clock signal CK rises from the low level Lo to the high level Hi.

For example, the L-lengths of the NMOS transistors (M4 and M6) and the two NMOS transistors in the data holding circuit 122 may be so adjusted that the L-lengths of the two NMOS transistors in the data holding circuit 122 are greater than the L-lengths of the NMOS transistors (M4 and M6). In addition, for example, the threshold voltages of the NMOS transistors (M4 and M6) and the two NMOS transistors in the data holding circuit 122 may be so adjusted that the threshold voltages of the two NMOS transistors in the data holding circuit 122 are lower than the threshold voltages of the NMOS transistors (M4 and M6). In addition, for example, the W-widths of the NMOS transistors (M4 and M6) and the two NMOS transistors in the data holding circuit 122 may be so adjusted that the W-widths of the two NMOS transistors in the data holding circuit 122 are greater than the W-widths of the NMOS transistors (M4 and M6).

In the present modification, the transistors of the latch circuit 120 are adjusted as described above. This makes it possible to suppress occurrence of malfunctioning of the latch circuit 120 caused by characteristic variation of the transistors of the latch circuit 120.

### [Modification B]

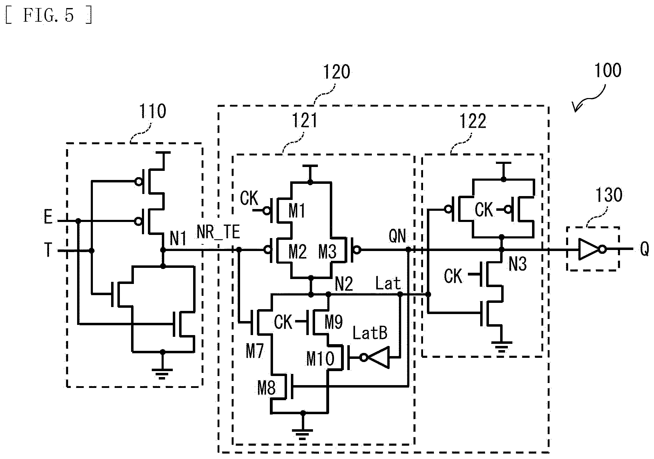

FIG. 5 illustrates a modification of the circuit configuration of the clock gating cell 100 according to the first embodiment. In the first embodiment, four transistors (M7 to M10) and one inverter may be provided in place of the three transistors (M4 to M6) between the node N2 and the ground line in the internal signal generation circuit 121. In the first embodiment, the state of the node N2 is determined by signals ((NR_TE + CK)·QN)) supplied to the three transistors (M4 to M6). However, in the present modification, the state of the node N2 is determined by signals (NR TE QN + CK LatB) supplied to the four transistors (M7 to M10). It is to be noted that LatB is a signal obtained by inverting Lat by the inverter.

In the present modification, the number of the transistors in the internal signal generation circuit 121 is increased by three. However, by providing the four transistors (M7 to M10) and the one inverter in place of the three transistors (M4 to M6), it is possible to solve a limitation in transition timings referred to in Modification A. That is, it is possible to suppress occurrence of malfunctioning of the latch circuit 120 caused by characteristic variation of the transistors of the latch circuit 120, by providing the four transistors (M7 to M10) and the one inverter in place of the three transistors (M4 to M6). In addition, it is also possible to reduce the size of the two NMOS transistors in the data holding circuit 122. In such a case, it is therefore possible to reduce gate capacitance of the clock signal CK.

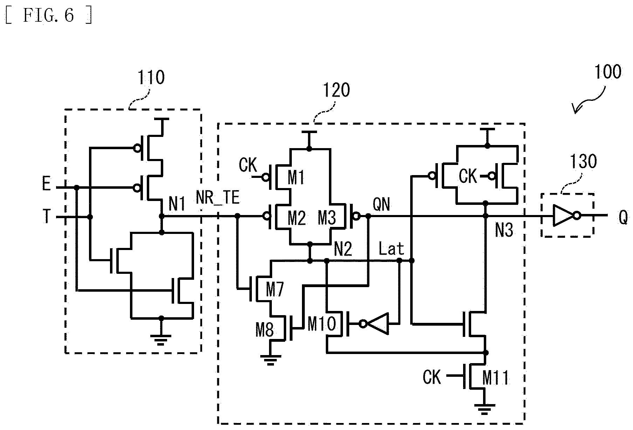

It is to be noted that in the latch circuit 120 according to the present modification, for example, as illustrated in FIG. 6, two NMOS transistors having the gates that receive the clock signal CK may be united to be shared. It is to be noted that M11 in FIG. 6 is the shared NMOS transistor. In such a case, it is possible to include twelve transistors in the latch circuit 120. In addition, this sharing allows the number of the PMOS transistors and the number of the NMOS transistors to be equal to each other in the latch circuit 120. It is therefore also possible to solve the imbalance of the circuit layout of the latch circuit 120.

### [Modification C]

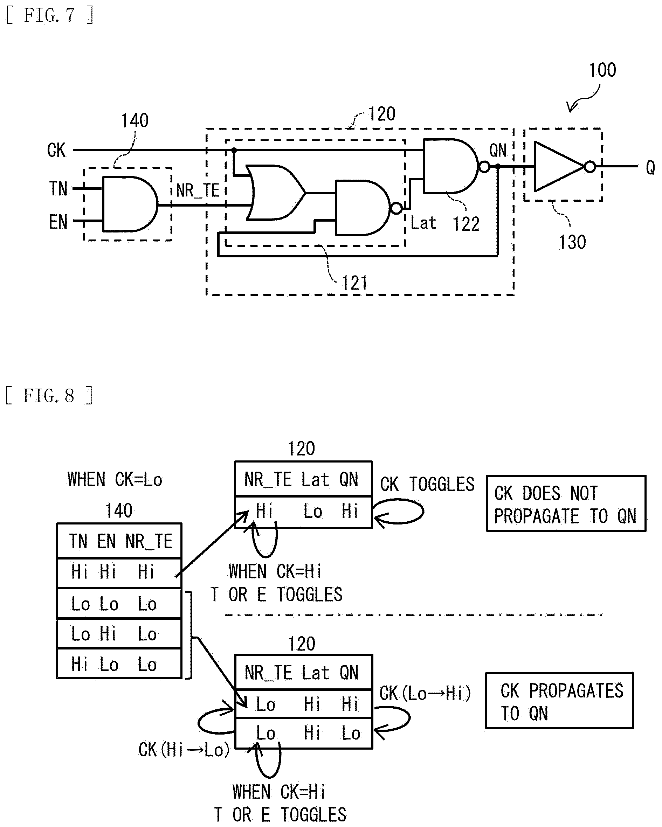

FIG. 7 illustrates a modification of the circuit configuration of the clock gating cell 100 according to the first embodiment and the modifications thereof. In the first embodiment and the modifications thereof, the clock gating cell 100 may have a configuration in which an enable generation section 140 is provided in place of the enable generation section 110.

The enable generation section 140 includes, for example, a two-input and one-output AND circuit, as illustrated in FIG. 7. This AND circuit receives enable signals EN and TN as input signals. This AND circuit outputs the enable signal NR_TE. The enable generation section 110 may include an AND circuit having three or more inputs in place of the two-input and one-output AND circuit.

In the two-input and one-output AND circuit, the enable signal NR_TE is set to the high level Hi when both of the two input signals (the enable signals EN and TN) are at the high level Hi (Disable) (see FIG. 8). In addition, in the two-input and one-output AND circuit, the enable signal NR_TE is set to the low level Lo when one or both of the input signals (the enable signal EN, the enable signal TN, or both) are set to the low level Lo (Enable) (see FIG. 8). That is, the enable signal NR_TE is set to the high level Hi only when both of the two input signals (the enable signals EN and TN) are at the high level Hi (Disable).

The internal signal generation circuit 121 outputs the low level Lo as the internal signal Lat when both of the two input signals (the enable signals EN and TN) are at the high level Hi (that is, when the enable signal NR_TE is at the high level Hi) (see FIG. 8). The internal signal generation circuit 121 outputs the high level Hi as the internal signal Lat when one or both of the input signals (the enable signal EN, the enable signal TN, or both) are at the low level Lo (see FIG. 8). The internal signal generation circuit 121 causes the clock signal CK to pass through as it is and supplies it to the data holding circuit 122. The data holding circuit 122 receives the clock signal CK and the internal signal Lat from the internal signal generation circuit 121.

That is, the latch section 120 includes a logic circuit that supplies the clock signal CK from the outside to one input node of the data holding circuit 122 (the two-input NAND circuit), and supplies the internal signal Lat at the low level Lo to another input node of the data holding circuit 122 (the two-input NAND circuit) when the enable signal NR_TE is set to the high level Hi while the clock signal is at the low level Lo.

When both of the two input signals (the enable signals EN and TN) are at the high level Hi, the data holding circuit 122 outputs the high level Hi as the output signal QN because the internal signal Lat remains at the low level Lo even if the clock signal CK toggles (see FIG. 8). That is, when both of the two input signals (the enable signals EN and TN) are at the high level Hi, the clock signal CK does not propagate to the output signal QN, and neither to the output signal Q of the output circuit 130.

In contrast, the data holding circuit 122 changes the output signal QN from the high level Hi to the low level Lo if the clock signal CK changes from the low level Lo to the high level Hi when one or both of the input signals (the enable signal EN, the enable signal TN, or both) are at the low level Lo (see FIG. 8). In addition, the data holding circuit 122 changes the output signal QN from the low level Lo to the high level Hi if the clock signal CK changes from the high level Hi to the low level Lo when one or both of the input signals (the enable signal EN, the enable signal TN, or both) are at the low level Lo (see FIG. 8). That is, when one or both of the input signals (the enable signal EN, the enable signal TN, or both) are at the low level Lo, the clock signal CK propagates to the output signal QN, and also to the output signal Q of the output circuit 130.

In the present modification, the latch circuit 120 includes the single phase clocking circuit including the NAND circuit. Using the single phase clocking circuit that does not use the inverted signal of the clock signal CK as described above makes it possible to suppress electric power dissipation corresponding to the toggling of the clock signal CK. In addition, this combined logic circuit 100 is provided with the inverter circuit (the output circuit 130) that inverts the output signal QN of the latch circuit 120. This makes it possible to form the AND circuit with the NAND circuit in the latch circuit 120 and the inverter circuit (the output circuit 130). It is therefore possible to suppress the circuit size, as compared with a case where the AND circuit is provided separately from the latch circuit 120.

In the present modification, the enable generation section 110 generates the control signal (the enable signal NR_TE) at the high level Hi when both of the enable signals EN and TN are at the high level Hi, and generates the control signal (the enable signal NR_TE) at the low level Lo when any of the enable signals EN and TN is at the low level Lo. Further, in the present modification, in the latch section 120, one input node of the data holding circuit 122 (the two-input NAND circuit) receives the clock signal CK supplied from the outside, and the other input node of the data holding circuit 122 (the two-input NAND circuit) receives the internal signal Lat at the low level Lo when the enable signal NR_TE is set to the high level Hi while the clock signal CK is at the low level Lo. In this case, even if the clock signal CK toggles, the output signal QN of the data holding circuit 122 (the two-input NAND circuit) remains at the high level Hi. That is, it goes without saying that the clock signal CK does not propagate to the output signal QN when both of the enable signals EN and TN are at the high level Hi. Further, regardless of how much the clock signal CK toggles, no node to be charged and discharged is present other than the gate terminal of the transistor to which the clock signal CK is coupled. Accordingly, it is possible to suppress electric power dissipation corresponding to the toggling of the clock signal CK when both of the enable signals EN and TN are at the high level Hi.

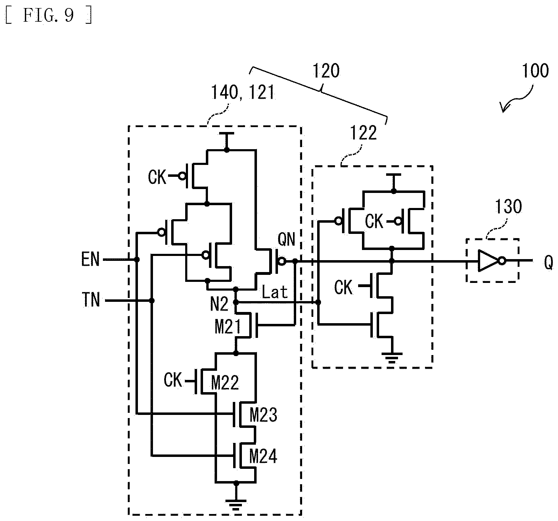

FIG. 9 illustrates an example of the circuit configuration of the clock gating cell 100 according to the present modification. In the clock gating cell 100 according to the present modification, the enable generation section 140 and the internal signal generation circuit 121 include, for example, eight transistors, as illustrated in FIG. 9. This makes it possible to reduce the circuit size, as compared with the first embodiment. In addition, in the present modification, the number of logic stages in the enable generation section 140 and the internal signal generation circuit 121 is less than the number of logic stages in the enable generation section 110 and the internal signal generation circuit 121 according to the first embodiment. It is therefore possible to improve the setup and the hold time of the enable signal, as compared with the first embodiment.

### [Modification D]

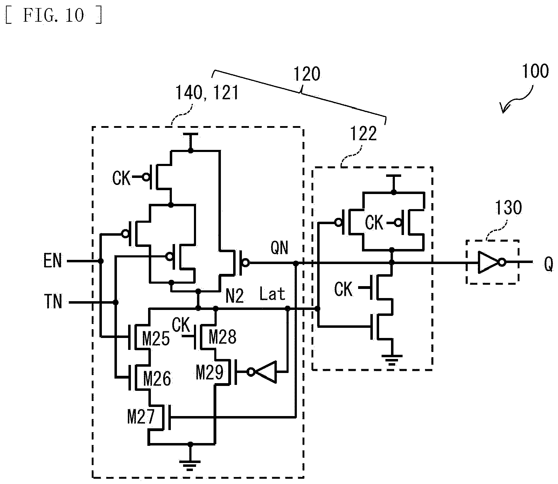

FIG. 10 illustrates a modification of the circuit configuration of the clock gating cell 100 according to Modification C described above. In Modification C described above, five transistors (M25 to M29) and one inverter illustrated in FIG. 10 may be provided in place of the four transistors (M21 to M24) illustrated in FIG. 9 between the node N2 and the ground line in the enable generation section 140 and the internal signal generation circuit 121. In Modification C described above, the state of the node N2 is determined by signals supplied to the four transistors (M21 to M24). However, in the present modification, the state of the node N2 is determined by signals supplied to the five transistors (M25 to M29).

In the present modification, the number of the transistors in the enable generation section 140 and the internal signal generation circuit 121 is increased by three, as compared with the number of the transistors in the enable generation section 110 and the internal signal generation circuit 121 according to the first embodiment. However, by providing the five transistors (M25 to M29) and the one inverter in place of the four transistors (M21 to M24), it is possible to solve a limitation in transition timings referred to in Modification A. That is, it is possible to suppress occurrence of malfunctioning of the enable generation section 140 and the internal signal generation circuit 121 by providing the five transistors (M25 to M29) and the one inverter in place of the four transistors (M21 to M24). In addition, it is also possible to reduce the size of the two NMOS transistors in the data holding circuit 122. In such a case, it is therefore possible to reduce the gate capacitance of the clock signal CK.

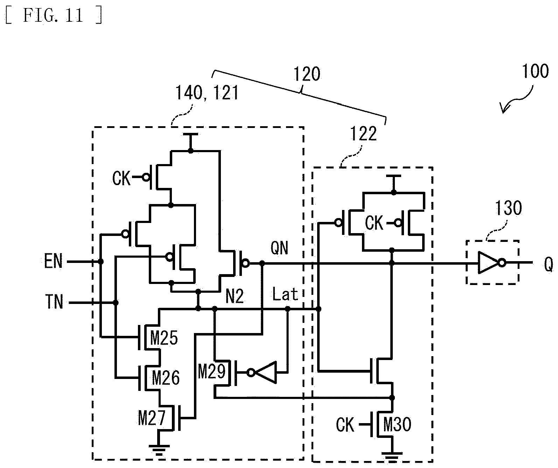

It is to be noted that in the enable generation section 140 and the latch circuit 120 according to the present modification, for example, as illustrated in FIG. 11, two NMOS transistors having the gates that receive the clock signal CK may be united to be shared. It is to be noted that M30 in FIG. 11 is the shared NMOS transistor. In such a case, it is possible to include fourteen transistors in the enable generation section 140 and the latch circuit 120. In addition, this sharing allows the number of the PMOS transistors and the number of the NMOS transistors to be equal to each other in the enable generation section 140 and the latch circuit 120. It is therefore also possible to solve the imbalance of the circuit layout of the enable generation section 140 and the latch circuit 120.

### [Modification E]

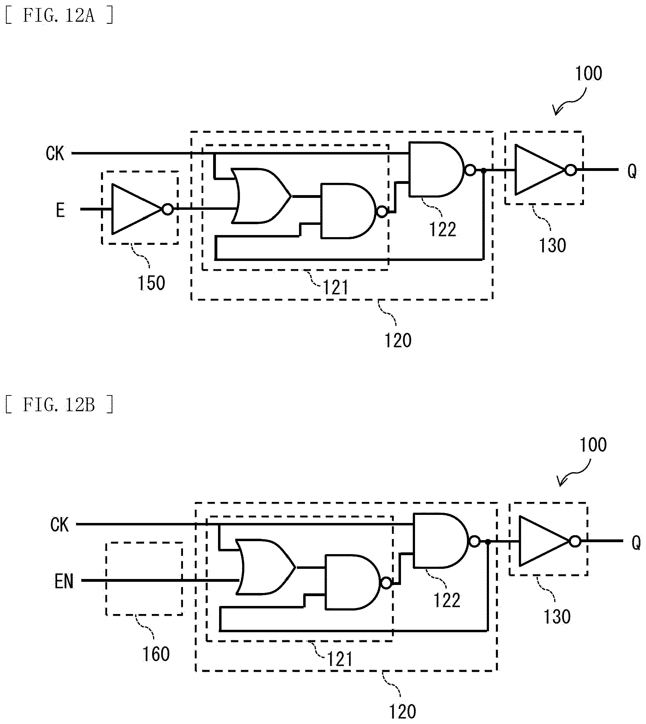

FIG. 12A illustrates a modification of the circuit configuration of the clock gating cell 100 according to the first embodiment and the modifications thereof. An enable generation section 150 is provided in place of the enable generation section 110 in the first embodiment and the modifications thereof. The enable generation section 150 includes, for example, an inverter, as illustrated in FIG. 12A. The enable generation section 150 supplies an inverted signal of the enable signal E to the latch circuit 120 as the enable signal NR_TE. The inverter includes, for example, two transistors (a PMOS transistor and an NMOS transistor). The inverter receives, for example, the enable signal E. In the present modification, the latch circuit 120 has a configuration similar to that of the latch circuit 120 according to the first embodiment and the modifications thereof. Accordingly, in the present modification, it is possible to achieve effects similar to those of the first embodiment and the modifications thereof.

### [Modification F]

FIG. 12B illustrates a modification of the circuit configuration of the clock gating cell 100 according to a modification of the first embodiment. An enable generation section 160 is provided in place of the enable generation section 110 in the first embodiment and the modifications thereof. The enable generation section 160 includes, for example, only a wiring line, as illustrated in FIG. 12B. The enable generation section 160 supplies the enable signal EN to the latch circuit 120 as the enable signal NR_TE. In the present modification, the latch circuit 120 has a configuration similar to that of the latch circuit 120 according to the first embodiment and the modifications thereof. Accordingly, in the present modification, it is possible to achieve effects similar to those of the first embodiment and the modifications thereof.

### <3. Second Embodiment>

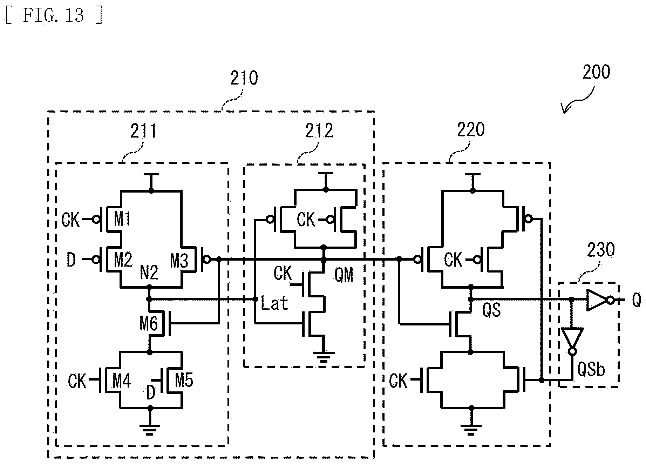

FIG. 13 illustrates an example of a circuit configuration of a flip-flop circuit 200 according to a second embodiment of the present disclosure. The flip-flop circuit 200 includes, for example, a master latch circuit 210, a slave latch circuit 220, and an output section 230, as illustrated in FIG. 13. The flip-flop circuit 200 receives a data signal D and a clock signal CK. The flip-flop circuit 200 outputs an output signal Q.

The data signal D is a signal indicating information of 1 bit, and is supplied to the master latch circuit 210. The clock signal CK is a signal for controlling an operation of the flip-flop circuit 200. The flip-flop circuit 200 samples data at a timing of rising of the clock signal CK and holds the data in a period other than that timing.

The master latch circuit 210 holds data or allows data to pass through on the basis of the clock signal CK. The master latch circuit 210 executes a predetermined logical operation on the clock signal CK and the data signal D. On the basis of a result of execution of the logical operation, when the clock signal CK is at the high level Hi, the master latch circuit 210 holds the data signal D latched at the latch and supplies it to the slave latch circuit 220 as an output signal QM. In contrast, when the clock signal CK is at the low level Lo, the master latch circuit 210 allows the data signal D to pass through and supplies it to the slave latch circuit 220 as the output signal QM.

The slave latch circuit 220 holds data or allows data to pass through on the basis of the clock signal CK. The slave latch circuit 220 executes a predetermined logical operation on the clock signal CK and the output signal QM. On the basis of a result of execution of the logical operation, when the clock signal CK is at the high level Hi, the slave latch circuit 220 allows the output signal QM to pass through and supplies it to the output section 230 as an output signal QS. In contrast, when the clock signal CK is at the low level Lo, the slave latch circuit 220 holds the output signal QM latched at the latch and supplies it to the output section 230 as the output signal QS.

The output section 230 is configured to include, for example, two inverters. In the output section 230, the two inverters receive the output signal QS, and the output (an inverted signal of the output signal QS) of one of the inverters is supplied from the output section 230 to an outside as the output signal Q. An output (an inverted signal of the output signal QS (an inverted signal QSb)) of another of the two inverters is fed back to the slave latch circuit 220.

The master latch circuit 210 includes, for example, an internal signal generation circuit 211 and a data holding section 212, as illustrated in FIG. 13. The internal signal generation circuit 211 has a configuration, for example, similar to that of the internal signal generation circuit 121 (e.g., the internal signal generation circuit 121 illustrated in FIG. 3) according to the embodiment and the modifications thereof described above. The data holding section 212 has a configuration, for example, similar to that of the data holding section 122 (e.g., the data holding section 122 illustrated in FIG. 3) according to the embodiment and the modifications thereof described above. The internal signal generation circuit 211 executes an operation similar to that of the internal signal generation circuit 211 according to the embodiment and the modifications thereof described above. The data holding section 212 executes an operation similar to that of the data holding section 122 according to the embodiment and the modifications thereof described above. However, the data signal D is supplied in place of the enable signal NR_TE.

In the present embodiment, the master latch circuit 210 includes a single phase clocking circuit including a NAND circuit. Using the single phase clocking circuit that does not use the inverted signal of the clock signal CK as described above makes it possible to suppress electric power dissipation corresponding to the toggling of the clock signal CK.

In the present embodiment, the data signal D as it is serves as the node corresponding to the enable signal NR_TE. In addition, in the present embodiment, in the master latch section 210, one input node of the data holding circuit 212 (the two-input NAND circuit) receives the clock signal CK from the outside, and another input node of the data holding circuit 212 (the two-input NAND circuit) receives the internal signal Lat at the low level Lo when the data signal D is set to the high level Hi while the clock signal CK is at the low level Lo. In this case, even if the clock signal CK toggles, the output signal QM of the data holding circuit 212 (the two-input NAND circuit) remains at the high level Hi. That is, the clock signal CK does not propagate to the output signal QM when the data signal D is at the high level Hi. Accordingly, it is possible to suppress electric power dissipation corresponding to the toggling of the clock signal CK when the data signal D is at the high level Hi.

In addition, in the master latch section 210 according to the present embodiment, for example, as illustrated in FIG. 13, in a case where the number of the PMOS transistors and the number of the NMOS transistors are equal to each other, it is possible to improve the balance of the circuit layout of the master latch section 210.

### <4. Modifications of Second Embodiment>

Next, a description is given of modifications of the flip-flop circuit 200 according to the second embodiment.

### [Modification F]

In the second embodiment, the transistors of the master latch circuit 210 may be so adjusted that the output signal QM of the data holding circuit 212 transitions from the high level Hi to the low level Lo before the output (the internal signal Lat) of the internal signal generation circuit 211 transitions from the high level Hi to the low level Lo when the clock signal CK rises from the low level Lo to the high level Hi.

For example, the L-lengths of the NMOS transistors (M4 and M6) and the two NMOS transistors in the data holding circuit 212 may be so adjusted that the L-lengths of the two NMOS transistors in the data holding circuit 212 are greater than the L-lengths of the NMOS transistors (M4 and M6). In addition, for example, the threshold voltages of the NMOS transistors (M4 and M6) and the two NMOS transistors in the data holding circuit 212 may be so adjusted that the threshold voltages of the two NMOS transistors in the data holding circuit 212 are lower than the threshold voltages of the NMOS transistors (M4 and M6). In addition, for example, the W-widths of the NMOS transistors (M4 and M6) and the two NMOS transistors in the data holding circuit 212 may be so adjusted that the W-widths of the two NMOS transistors in the data holding circuit 212 are greater than the W-widths of the NMOS transistors (M4 and M6).

In the present modification, the transistors of the master latch circuit 210 are adjusted as described above. This makes it possible to suppress occurrence of malfunctioning of the master latch circuit 210 caused by characteristic variation of the transistors of the master latch circuit 210.

### [Modification G]

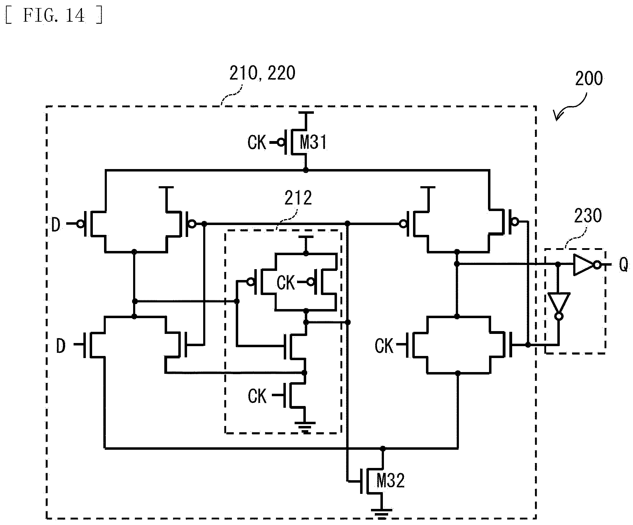

FIG. 14 illustrates a modification of the circuit configuration of the flip-flop circuit 200 according to the second embodiment. In the second embodiment, for example, as illustrated in FIG. 14, one PMOS transistor on the constant voltage line side in the internal signal generation circuit 211 of FIG. 13 and one PMOS transistor on the constant voltage line side in the slave latch section 220 of FIG. 13 may be united to be shared. It is to be noted that M31 in FIG. 14 is the shared PMOS transistor. In addition, in the present modification, for example, as illustrated in FIG. 14, one NMOS transistor on the ground line side in the internal signal generation circuit 211 of FIG. 13 and one NMOS transistor on the ground line side in the slave latch section 220 illustrated in FIG. 13 may be united to be shared. It is to be noted that M32 in FIG. 14 is the shared NMOS transistor. In such a case, it is possible to include fourteen transistors in the master latch circuit 210 and the slave latch section 220. In addition, this sharing allows the number of the PMOS transistors and the number of the NMOS transistors to be equal to each other in the master latch circuit 210 and the slave latch section 220. It is therefore also possible to solve the imbalance of the circuit layout of the master latch circuit 210 and the slave latch section 220.

### [Modification H]

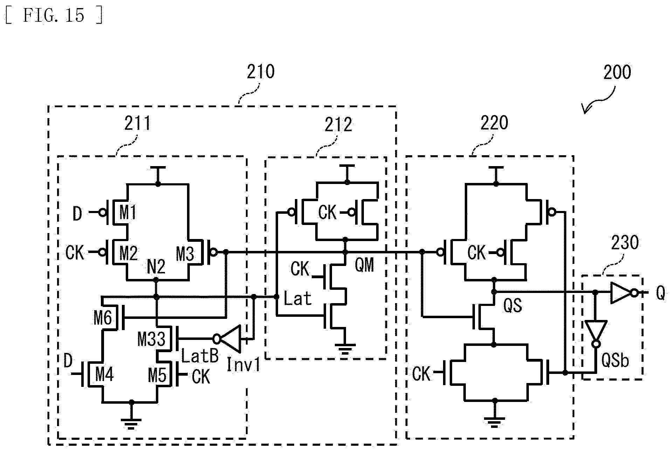

FIG. 15 illustrates a modification of the circuit configuration of the flip-flop circuit 200 according to the second embodiment. In the second embodiment, the master latch circuit 210 may further include one transistor (an NMOS transistor (M33)) and one inverter Inv1. The inverter Inv1 receives the internal signal Lat, and a signal (an inverted signal LatB) obtained by inverting the internal signal Lat by the inverter Inv1 is supplied to the gate of the transistor M33. The transistors M4 and M6 are coupled to each other in series, and the transistors M5 and M33 are coupled to each other. In addition, the transistors M4 and M6 coupled to each other in series and the transistors M5 and M33 that are coupled to each other in series are coupled to each other in parallel.

In the second embodiment, the state of the node N2 is determined by signals ((D + CK)·QM)) supplied to the three transistors (M4 to M6). However, in the present modification, the state of the node N2 is determined by signals (D·QM + CK LatB) supplied to the four transistors (M4 to M6 and M33).

In the present modification, the number of the transistors in the internal signal generation circuit 211 is increased by three. However, by providing the four transistors (M4 to M6 and M33) and the one inverter Inv1 in place of the three transistors (M4 to M6), it is possible to solve a limitation in transition timings referred to in Modification A. That is, it is possible to cause the output signal QN of the data holding circuit 122 to transition from the high level Hi to the low level Lo before the output (the internal signal Lat) of the internal signal generation circuit 121 transitions from the high level Hi to the low level Lo by providing the four transistors (M4 to M6 and M33) and the one inverter Inv1 in place of the three transistors (M4 to M6). Accordingly, it is possible to suppress occurrence of malfunctioning of the master latch circuit 210 caused by characteristic variation of the transistors of the master latch circuit 210. In addition, it is also possible to reduce the size of the two NMOS transistors in the data holding circuit 212. In such a case, it is therefore possible to reduce the gate capacitance of the clock signal CK.

### [Modification I]

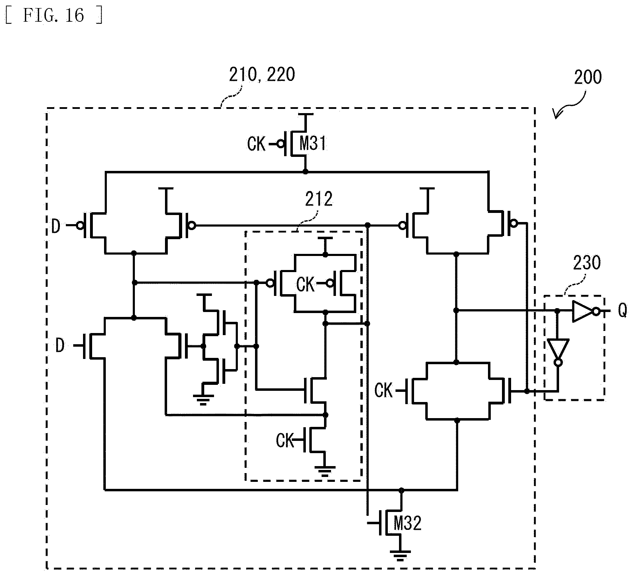

FIG. 16 illustrates a modification of the circuit configuration of the flip-flop circuit 200 according to Modification H. In Modification H, for example, as illustrated in FIG. 16, one PMOS transistor on the constant voltage line side in the internal signal generation circuit 211 of FIG. 15 and one PMOS transistor on the constant voltage line side in the slave latch section 220 of FIG. 15 may be united to be shared. It is to be noted that M31 in FIG. 16 is the shared PMOS transistor. In addition, in the present modification, for example, as illustrated in FIG. 16, one NMOS transistor on the ground line side in the internal signal generation circuit 211 illustrated in FIG. 15 and one NMOS transistor on the ground line side in the slave latch section 220 of FIG. 15 may be united to be shared. It is to be noted that M32 in FIG. 16 is the shared PMOS transistor. In addition, in the present modification, for example, as illustrated in FIG. 16, one transistor included in the inverter Inv1 of FIG. 15 and the transistor M33 of FIG. 15 may be united to be shared.

In such a case, it is possible to include sixteen transistors in the master latch circuit 210 and the slave latch section 220. In addition, this sharing allows the number of the PMOS transistors and the number of the NMOS transistors to be equal to each other in the master latch circuit 210 and the slave latch section 220. It is therefore also possible to solve the imbalance of the circuit layout of the master latch circuit 210 and the slave latch section 220.

### [Modification J]

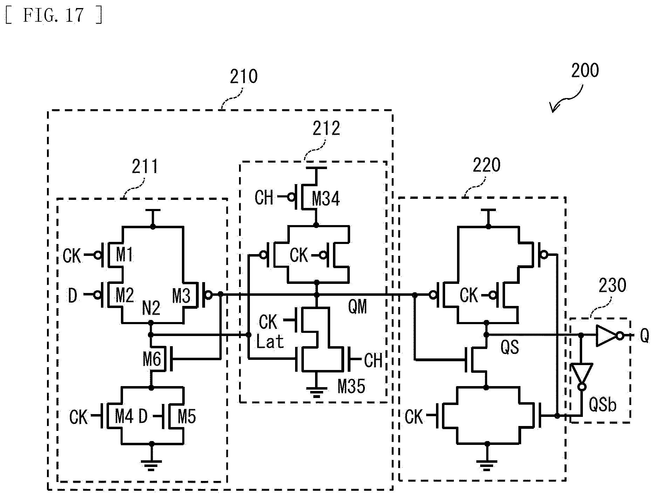

FIG. 17 illustrates a modification of the circuit configuration of the flip-flop circuit 200 according to the second embodiment. In the second embodiment, the data holding circuit 212 may be configured to execute a clear operation of causing the output signal Q to be zero (0). The data holding circuit 212 may further include, for example, a transistor (M34) (a PMOS transistor) and a transistor (M35) (an NMOS transistor), as illustrated in FIG. 17.

In the data holding circuit 212, the transistor (M34) is provided between the constant voltage line and the two PMOS transistors coupled to each other in parallel. The gate of the transistor (M34) receives a reset signal CH. In the data holding circuit 212, the transistor (M35) is coupled in parallel to the two NMOS transistors that are coupled to each other in series. The gate of the transistor (M35) receives the reset signal CH. It is thus possible to achieve a clear function only by adding the two transistors (M34 and M35) to the data holding circuit 212.

### [Modification K]

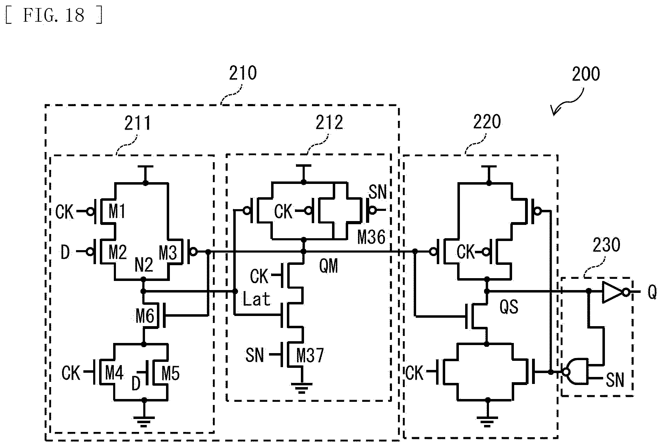

FIG. 18 illustrates a modification of the circuit configuration of the flip-flop circuit 200 according to the second embodiment. In the second embodiment, the data holding circuit 212 and the output circuit 230 may be configured to execute a set operation of causing the output signal Q to be 1. The data holding circuit 212 may further include, for example, a transistor (M36) (a PMOS transistor) and a transistor (M37) (an NMOS transistor), as illustrated in FIG. 18.

In the data holding circuit 212, the transistor (M36) is coupled in parallel to the two PMOS transistors that are coupled to each other in parallel. The gate of the transistor (M36) receives a control signal SN. In the data holding circuit 212, the transistor (M37) is coupled in series to the two NMOS transistors that are coupled to each other in series. The gate of the transistor (M37) receives the control signal SN.

The output circuit 230 includes a NAND circuit in place of the inverter for feeding the output signal Q back to the data holding circuit 212. This NAND circuit receives the output signal Q and a set signal SN as input signals. An output signal of this NAND circuit is supplied to the gate of one PMOS transistor of the data holding circuit 212 and to the gate of one NMOS transistor of the data holding circuit 212. It is possible to achieve a set function by adding the two transistors (M36 and M37) to the data holding circuit 212 and providing the NAND circuit, in the output circuit 230, in place of the inverter as described above.

### [Modification L]

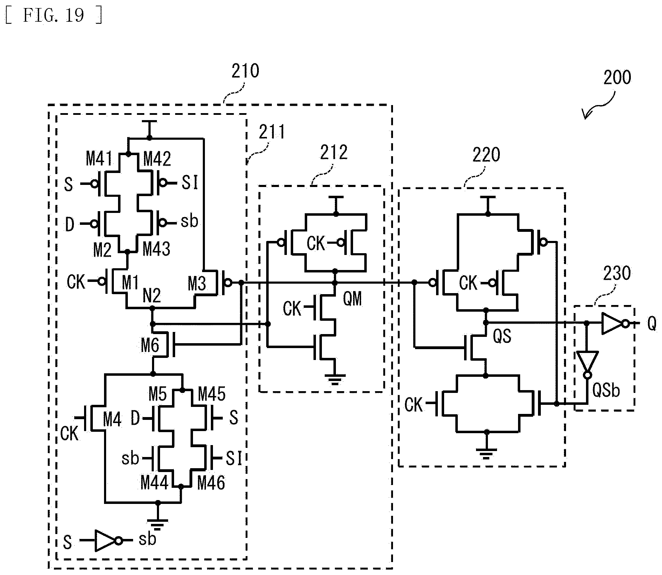

FIG. 19 illustrates a modification of the circuit configuration of the flip-flop circuit 200 according to the second embodiment. In the second embodiment, the internal signal generation circuit 211 may include a logic circuit that selects data signals D and SI. The internal signal generation circuit 211 includes, for example, a logic circuit that selects one of the data signal D or the test signal SI on each of the constant voltage line side and the ground line side, as illustrated in FIG. 19.

The logic circuit on the constant voltage line side includes, for example, four NMOS transistors (M2, M41, M42, and M43). The NMOS transistors (M2 and M41) are coupled to each other in series, and the NMOS transistors (M42 and M43) are coupled to each other in series. The NMOS transistors (M2 and M41) that are coupled to each other in series and the NMOS transistors (M42 and M43) that are coupled to each other in series are coupled to each other in parallel. The gate of the NMOS transistor (M2) receives the data signal D, the gate of the NMOS transistor (M41) receives a control signal S, the gate of the NMOS transistor (M42) receives the test signal SI, and the gate of the NMOS transistor (M43) receives an inverted signal (an inverted signal sb) of the control signal S.

The logic circuit on the ground line side includes, for example, four PMOS transistors (M4, M44, M45, and M46). The PMOS transistors (M5 and M44) are coupled to each other in series, and the PMOS transistors (M45 and M46) are coupled to each other in series. The PMOS transistors (M5 and M44) that are coupled to each other in series and the PMOS transistors (M45 and M46) that are coupled to each other in series are coupled to each other in parallel. The gate of the PMOS transistor (M5) receives the data signal D, the gate of the PMOS transistor (M44) receives the inverted signal sb, the gate of the PMOS transistor (M45) receives the control signal S, and the gate of the PMOS transistor (M46) receives the test signal SI.

### [Modification M]

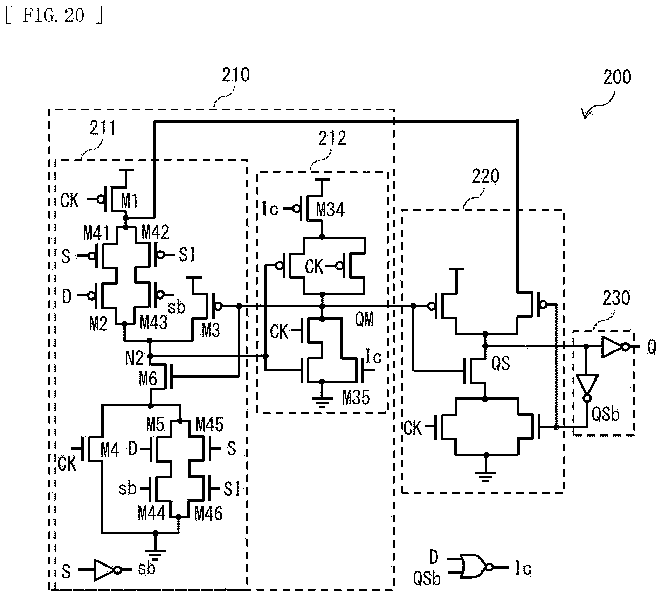

FIG. 20 illustrates a modification of the circuit configuration of the flip-flop circuit 200 according to Modification L. In Modification L, the data holding circuit 212 may further include, for example, a transistor (M34) (a PMOS transistor) and a transistor (M35) (an NMOS transistor), as illustrated in FIG. 20. In addition, in the internal signal generation circuit 211 according to Modification L, the PMOS transistor (M1) is provided closer to the constant voltage line than the four transistors (M2 and M41 to M43). In addition, in the slave latch section 220 according to Modification L, the PMOS transistor to receive the clock signal CK is omitted, and the PMOS transistor to receive the inverted signal QSb is coupled to the PMOS transistor (M1) in parallel.

In the present modification, a NOR circuit is provided that performs a NOR logical operation on the data signal D and the inverted signal QSb. An output (a control signal Ic) of this NOR circuit is supplied to the gates of the PMOS transistor (M34) and the NMOS transistor (M35). When both the input signal (the data signal D) and the output signal Q are zero (0), it is thus possible to reset the master latch section 210 and the slave latch section 220. As a result, it is possible to avoid wasteful charging and discharging by the toggling of the clock signal CK at the time when the input signal (the data signal D) is at the low level Lo.

In a usual flip-flop circuit, it is necessary to use an EXNOR of the input signal (the data signal D) and the output signal Q in order to add an internal redundant toggling suppression function. In contrast, in the flip-flop circuit 200 according to the present modification, because the internal redundant toggling is not occurring in the first place when the input signal (the data signal D) is at the high level Hi, it is enough to perform reset only when the input signal (the data signal D) is at the low level Lo. It is therefore possible to perform reset with a simple NOR (that is, with fewer transistors) instead of the EXNOR.

### [Modification O]

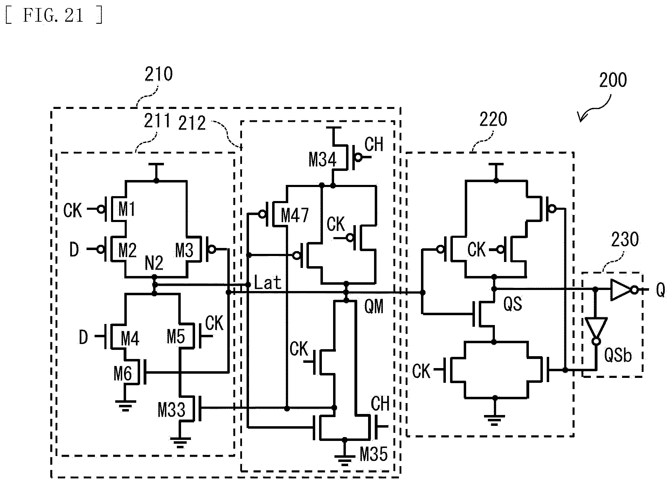

FIG. 21 illustrates a modification of the circuit configuration of the flip-flop circuit 200 according to Modification H. In Modification H, the data holding circuit 212 may further include, for example, a transistor (M34) (a PMOS transistor), a transistor (M35) (an NMOS transistor), and a transistor (M47) (a PMOS transistor), as illustrated in FIG. 20, as compared with the data holding circuit 212 of FIG. 15.

The transistor (M47) is coupled in series to the transistor (M34), and is also coupled in series to the NMOS transistor that receives the internal signal Lat in the data holding circuit 212. The gate of the transistor (M47) receives the internal signal Lat. The gates of the PMOS transistor (M34) and the NMOS transistor (M35) receive the reset signal CH. Clear is enabled when the reset signal CH is set to the high level Hi, and Clear is disabled when the reset signal CH is set to the low level Lo. It is to be noted that the serial order of the transistors is changed in some points in FIG. 21 from that in FIG. 15, but this does not influence the circuit logic itself.

Adding the three transistors (M34, M35, and M47) to the data holding circuit 212 as described above makes it possible to achieve the clear function and also makes it possible to use another transistor also as the transistor included in the inverter Inv1.

### [Modification P]

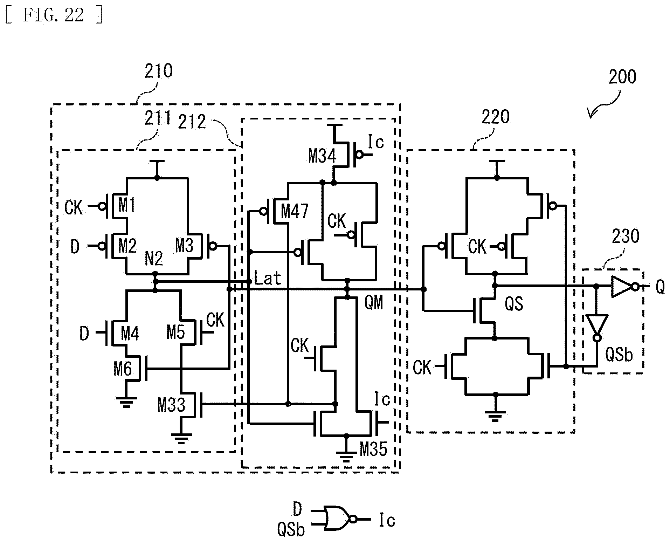

FIG. 22 illustrates a modification of the circuit configuration of the flip-flop circuit 200 according to Modification O. In Modification O, a NOR circuit may be provided that performs a NOR logical operation on the data signal D and the inverted signal QSb. An output (the control signal Ic) of this NOR circuit is supplied to the gates of the PMOS transistor (M34) and the NMOS transistor (M35). When both the input signal (the data signal D) and the output signal Q are zero (0), it is thus possible to reset the master latch section 210 and the slave latch section 220. As a result, it is possible to avoid wasteful charging and discharging by the toggling of the clock signal CK at the time when the input signal (the data signal D) is at the low level Lo.

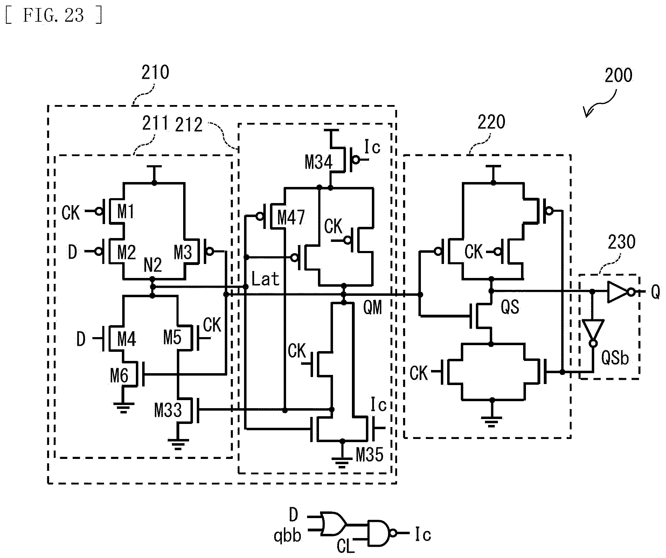

It is to be noted that in the present modification, for example, as illustrated in FIG. 23, a three-input OAI (Or And Inverter) may be provided in place of the NOR circuit described above. The three-input OAI includes a NOR circuit and a NAND circuit. The NOR circuit performs a NOR logical operation on the data signal D and the inverted signal QSb. The NAND circuit performs a NAND logical operation on an output signal of this NOR circuit and a reset signal CL. An output of the three-input OAI (an output of the NAND circuit) is supplied to the gates of the PMOS transistor (M34) and the NMOS transistor (M35) as the control signal Ic. Clear is enabled when the control signal Ic is set to the low level Lo, and Clear is disabled when the control signal Ic is set to the high level Hi.

### [Modification Q]

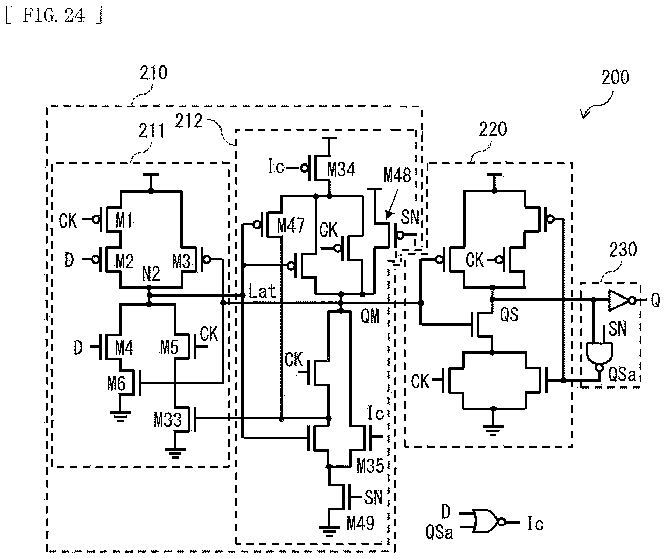

FIG. 24 illustrates a modification of the circuit configuration of the flip-flop circuit 200 according to Modification O. In Modification O, the data holding circuit 212 and the output circuit 230 may be configured to execute the set operation of causing the output signal Q to be 1. The data holding circuit 212 may further include, for example, a transistor (M48) (a PMOS transistor) and a transistor (M49) (an NMOS transistor), as illustrated in FIG. 24.

In the data holding circuit 212, the transistor (M48) is coupled in parallel to the two PMOS transistors (the transistor (M34) and the transistor that receives the clock signal CK) that are coupled to each other in series. The gate of the transistor (M48) receives a controls signal QSa (which will be described later). In the data holding circuit 212, the transistor (M49) is coupled in series to the NMOS transistor (M35) that receives the clock signal CK. The gate of the transistor (M49) receives the control signal QSa.

The output circuit 230 includes a two-input and one-output NAND circuit in place of the inverter for feeding the output signal Q back to the data holding circuit 212. This NAND circuit receives the output signal Q and the set signal SN as input signals. An output signal (the control signal QSa) of this NAND circuit is supplied to the two transistors (M48 and M49). It is possible to achieve the set function by adding the two transistors (M48 and M49) to the data holding circuit 212 and providing the NAND circuit in the output circuit 230 in place of the inverter as described above.

For example, upon automatically performing the reset, the transistors (M34 and M35) that receive the control signal Ic attempt to set the output signal QM to the low level Lo. Meanwhile, upon performing the set operation, the transistors (M48 and M49) that receive the set signal SN from the outside attempt to set the output signal QM to the high level Hi. In order to give priority to the set operation by the set signal SN supplied from the outside, the transistors (M48 and M49) are disposed at positions closer to the ground line than the transistors (M34 and M35).

### <3. Third Embodiment>

### [Configuration]

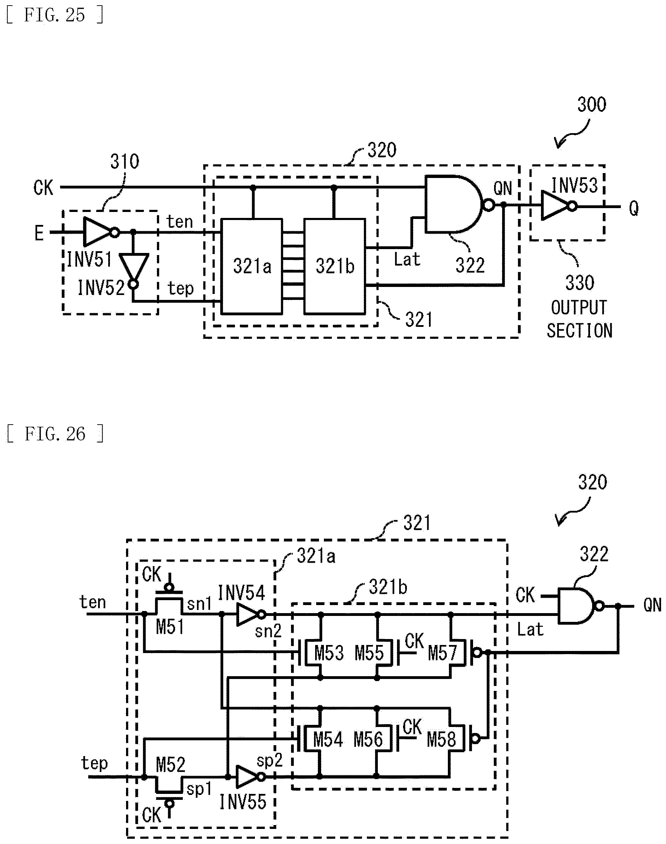

FIG. 25 illustrates an example of functional blocks of a clock gating cell 300 according to a third embodiment of the present disclosure. The clock gating cell 300 is, for example, a circuit for stopping a clock supplied to a register with no change in data and suppressing unnecessary electric power dissipation in the register. The clock gating cell 300 includes an enable generation section 310, a latch section 320, and an output section 330. The clock gating cell 300 receives a clock signal CK and an enable signal E for system. The clock gating cell 300 outputs an output signal Q. The clock signal CK is a signal for controlling an operation of the clock gating cell 300. The output signal Q is, for example, a signal supplied to the register or the like.

The enable generation section 310 includes, for example, two inverters INV51 and INV 52, as illustrated in FIG. 25. The inverter INV51 receives the enable signal E as an input signal. The inverter INV51 outputs an inverted signal (a control signal ten) of the enable signal E. The inverter INV52 receives, as an input signal, the control signal ten that is an output signal of the inverter INV51. The inverter INV52 outputs an inverted signal (a control signal tep) of the control signal ten. The enable generation section 310 receives the enable signal E as an input signal, and the enable generation section 310 outputs the control signals ten and tep.

In the enable generation section 310, the control signal ten is set to the high level Hi (Enable) and the control signal tep is set to the low level Lo when the enable signal E is at the low level Lo (Disable). In addition, in the enable generation section 310, the control signal ten is set to the low level Lo and the control signal tep is set to the high level Hi when the enable signal E is at the high level Hi.

The latch section 320 is a latch circuit (a single phase clocking latch circuit) that includes a single phase clocking circuit including a NAND circuit. As illustrated in FIG. 25, the latch section 320 includes, for example, an internal signal generation circuit 321 and a data holding circuit 322. The internal signal generation circuit 321 uses the control signals ten and tep.

The internal signal generation circuit 321 outputs the low level Lo as an internal signal Lat when the enable signal E is at the low level Lo (that is, when the control signal ten is at the high level Hi and the control signal tep is at the low level Lo). The internal signal generation circuit 321 outputs the high level Hi as the internal signal Lat when the enable signal E is at the high level Hi (that is, when the control signal ten is at the low level Lo and the control signal tep is at the high level Hi). The internal signal generation circuit 321 causes the clock signal CK to pass through as it is and supplies it to the data holding circuit 322. The data holding circuit 322 receives the clock signal CK and the internal signal Lat from the internal signal generation circuit 321.

That is, the latch section 320 includes a logic circuit that supplies the clock signal CK to one input node of the data holding circuit 322 (a two-input NAND circuit), and supplies the internal signal Lat at the low level Lo to another input node of the data holding circuit 322 (the two-input NAND circuit) when the enable signal E is set to the low level Lo while the clock signal is at the low level Lo.

When the enable signal E is at the low level Lo, the data holding circuit 322 outputs the high level Hi as an output signal QN because the internal signal Lat remains at the low level Lo even if the clock signal CK toggles. That is, when the enable signal E is at the low level Lo, the clock signal CK does not propagate to the output signal QN, and neither to an output signal Q of the output circuit 130.

In contrast, the data holding circuit 322 changes the output signal QN from the high level Hi to the low level Lo if the clock signal CK changes from the low level Lo to the high level Hi when the enable signal E is at the high level Hi. In addition, the data holding circuit 322 changes the output signal QN from the low level Lo to the high level Hi if the clock signal CK changes from the high level Hi to the low level Lo when the enable signal E is at the high level Hi. That is, when the enable signal E is at the high level Hi, the clock signal CK propagates to the output signal QN, and also to the output signal Q of the output circuit 230.

The internal signal generation circuit 321 includes, for example, a latch circuit 321a and an assist circuit 321b, as illustrated in FIG. 25. The latch circuit 321a receives the control signals ten and tep and the clock signal CK. The latch circuit 321a outputs the control signals ten and tep and internal signals sn1, sn2, sp1, and sp2. The assist circuit 321b receives the control signals ten and tep, the internal signals sn1, sn2, sp1, and sp2, the clock signal CK, and the output signal QN. The assist circuit 321b outputs the internal signal Lat.

The latch circuit 321a latches the states of the control signals ten and tep when the clock signal CK is at the low level Lo. The latch circuit 321a is an SRAM latch circuit. As illustrated in FIG. 26, the latch circuit 321a are configured to include, for example, two NMOS transistors M51 and M52 and two inverters INV54 and 55.

In the NMOS transistor M51, one source and drain terminal is coupled to a terminal that receives the control signal ten and the assist circuit 321b. Another source and drain terminal thereof is coupled to the input terminal of the inverter INV54 and the assist circuit 321b. The gate of the NMOS transistor M51 is coupled to the terminal that receives the clock signal CK. In the NMOS transistor M52, one source and drain terminal is coupled to a terminal that receives the control signal tep and the assist circuit 321b. Another source and drain terminal thereof is coupled to the input terminal of the inverter INV55 and the assist circuit 321b. The gate of the NMOS transistor M52 is coupled to a terminal that receives the clock signal CK. Output terminals of the inverters INV54 and 55 are each coupled to the assist circuit 321b.

The assist circuit 321b is a circuit that corrects the internal signal Lat which is to be written in the data holding circuit 322. The assist circuit 321b has a function of preventing a phenomenon called "Vth drop" and a function of preventing "data collision upon writing". The "Vth drop" refers to a phenomenon in which, due to the presence of each of the pass-transistors (the NMOS transistors M51 and M52) in the latch circuit 321a, the signal level increases only up to a value that is lower than a desired value by a value corresponding to a threshold voltage Vth of the pass-transistor. The "data collision upon writing" refers to that both the signal (the control signal sn2) from a first path (a path including the NMOS transistor M51 and the inverter INV54) in the latch circuit 321a and the signal (the control signal sp2) from a second path (a path including the NMOS transistor M52 and the inverter INV55) in the latch circuit 321a are supplied to the data holding circuit 322. When this "data collision upon writing" occurs, the data holding circuit 322 performs an operation that differs from a desired operation (malfunctions). The assist circuit 321b supplies, to the data holding circuit 322, a signal corresponding to the state not causing the "Vth drop" to occur out of the states of the control signals ten and tep latched by the latch circuit 321a, as the internal signal Lat.

The assist circuit 321b is configured to include, for example, four PMOS transistors M53 to M56 and two NMOS transistors M57 and 58, as illustrated in FIG. 26. The PMOS transistor M53, the PMOS transistor M55, and the NMOS transistor M57 are coupled to each other in parallel. In the PMOS transistor M53, the PMOS transistor M55, and the NMOS transistor M57, one source and drain terminal is coupled to a wiring line through which the control signal sn2 propagates, and another source and drain terminal is coupled to a wiring line through which the control signal sp1 propagates. The PMOS transistor M54, the PMOS transistor M56, and the NMOS transistor M58 are coupled to each other in parallel. In the PMOS transistor M54, the PMOS transistor M56, and the NMOS transistor M58, one source and drain terminal is coupled to a wiring line through which the control signal sn1 propagates, and another source and drain terminal is coupled to a wiring line through which the control signal sp2 propagates.

The gate of the PMOS transistor M53 is coupled to the terminal that receives the control signal ten. The gate of the PMOS transistor M54 is coupled to the terminal that receives the control signal tep. The gate of the PMOS transistor M55 is coupled to the terminal that receives the clock signal CK. The gate of the PMOS transistor M56 is coupled to the terminal that receives the clock signal CK. The gate of the PMOS transistor M57 is coupled to the terminal, of the data holding circuit 122, that outputs the output signal QN. The gate of the PMOS transistor M58 is coupled to the terminal, of the data holding circuit 122, that outputs the output signal QN.

The data holding circuit 322 includes, for example, two-input and one-output NAND circuit, as illustrated in FIG. 25. The NAND circuit receives the clock signal CK and the internal signal Lat of the internal signal generation circuit 321. The output signal QN of the NAND circuit is supplied to the assist circuit 321b and the output section 330.

The output circuit 330 is an inverter that inverts the output signal (the output signal QN) of the data holding circuit 322, and outputs the inverted signal of the output signal QN as the output signal Q. The inverter includes, for example, two transistors (a PMOS transistor and an NMOS transistor). In the clock gating cell 300, the NAND circuit of the data holding circuit 322 and the inverter of the output circuit 330 form an AND circuit. That is, in the clock gating cell 300, a circuit (the NAND circuit) of a portion of the latch section 320 also serves as a portion of the AND circuit provided on the stage after the latch section 320.

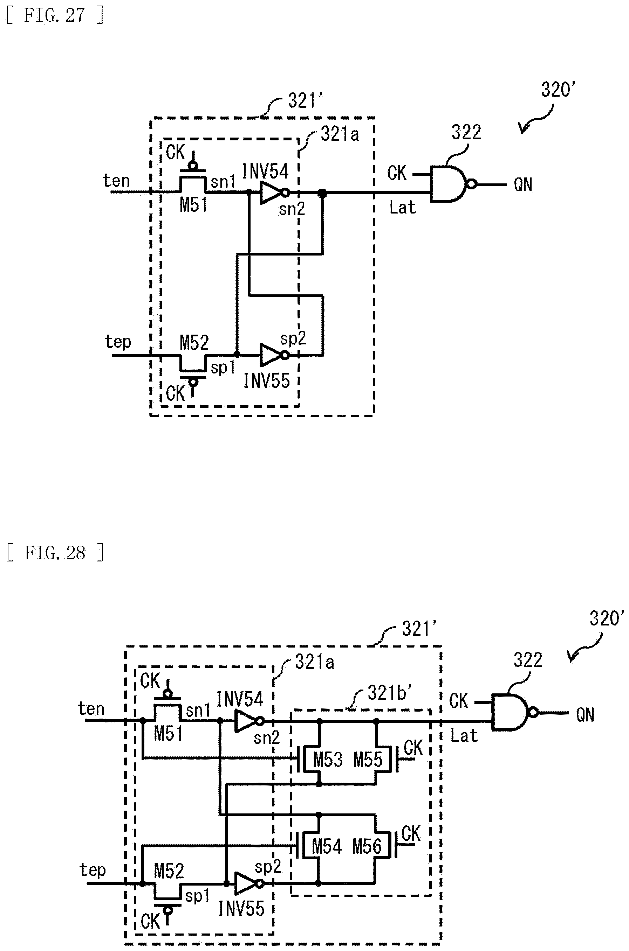

FIGs. 27 and 28 illustrate examples of a circuit configuration of a latch section 320' according to a comparative example. The latch section 320' illustrated in FIG. 27 is a circuit in which the assist circuit 321b is omitted in the latch section 320, the output terminal of the inverter INV54 is coupled to the input terminal of the inverter INV55, and the output terminal of the inverter INV55 is coupled to the input terminal of the inverter INV54. The latch section 320' illustrated in FIG. 28 is a circuit in which the PMOS transistors M57 and M58 are omitted in the latch section 320.

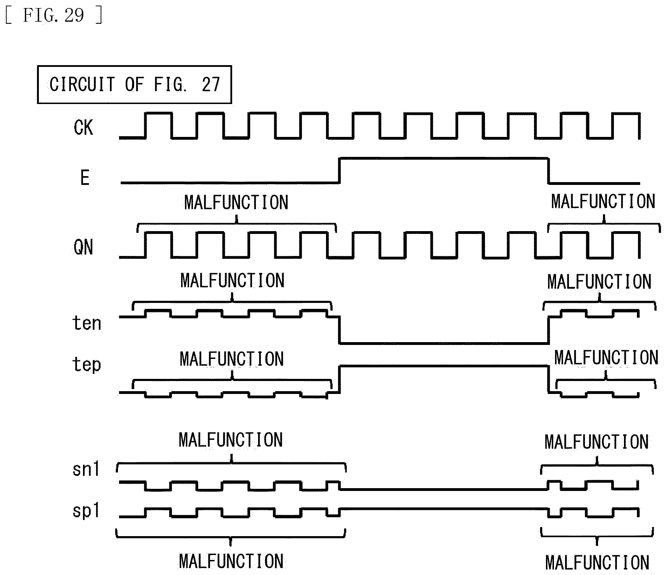

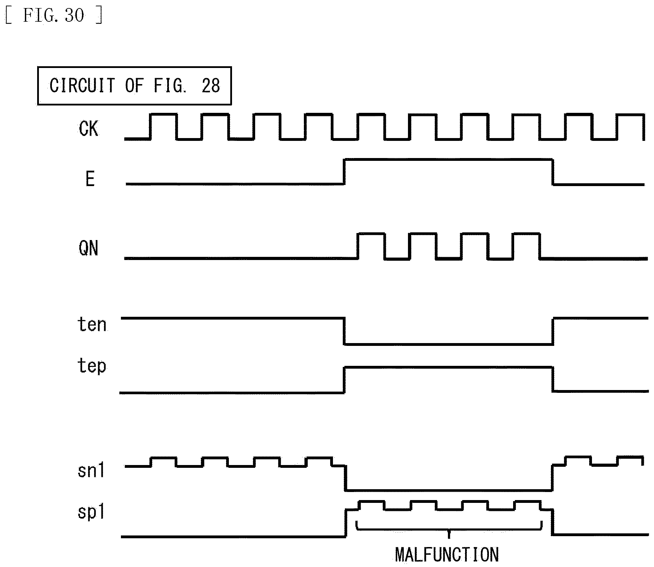

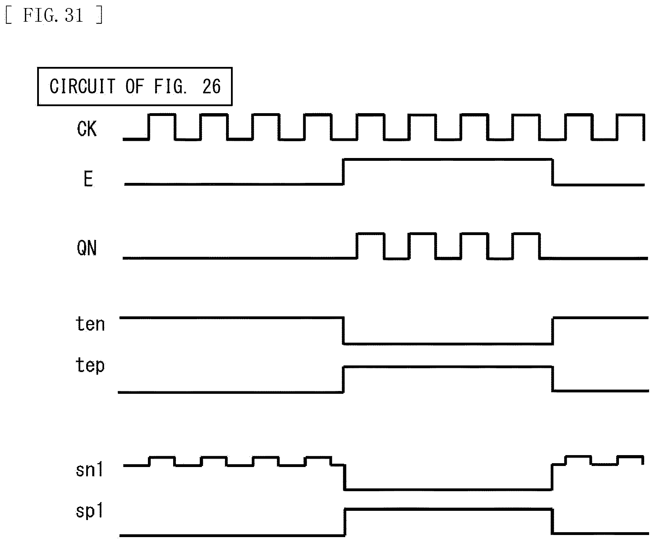

FIG. 29 is a waveform diagram of the clock gating cell 300 including the latch section 320' illustrated in FIG. 27. FIG. 30 is a waveform diagram of the clock gating cell 300 including the latch section 320' illustrated in FIG. 28. FIG. 31 is a waveform diagram of the clock gating cell 300 including the latch section 320 illustrated in FIG. 26. The "malfunction" described in FIGs. 29 and 30 represents that the waveform is different from the waveform illustrated in FIG. 31.

As illustrated in FIG. 29, in the clock gating cell 300 including the latch section 320' illustrated in FIG. 27, the voltage undergoes the "Vth drop". The level of the "Vth drop" changes depending on manufacturing variation. A through-current caused by a midpoint potential is increased by an influence of the "Vth drop". In particular, if the manufacturing variation is great, the "Vth drop" beyond the logical threshold can occur. This makes it difficult to perform data writing or data holding in the latch section and can cause malfunctioning. In a case where the "data collision upon writing" is present, it is necessary to adjust the transistor sizes (the W-length and driving performance) on the writing side and the holding side to secure writing, and it is necessary to make the writing side have sufficiently large size taking into consideration the manufacturing variation, as compared with the holding side. In the present circuit, the "data collision upon writing" does not occur. It is therefore possible to make both pch and nch have the minimum sizes.

In contrast, in the clock gating cell 300 including the latch section 320 illustrated in FIG. 26, the "Vth drop" as illustrated in FIG. 29 or the "data collision upon writing" does not occur. In addition, because the PMOS transistors M57 and M58 are provided, the voltage of sp1 is prevented from shifting when the clock signal CK is at the high level.

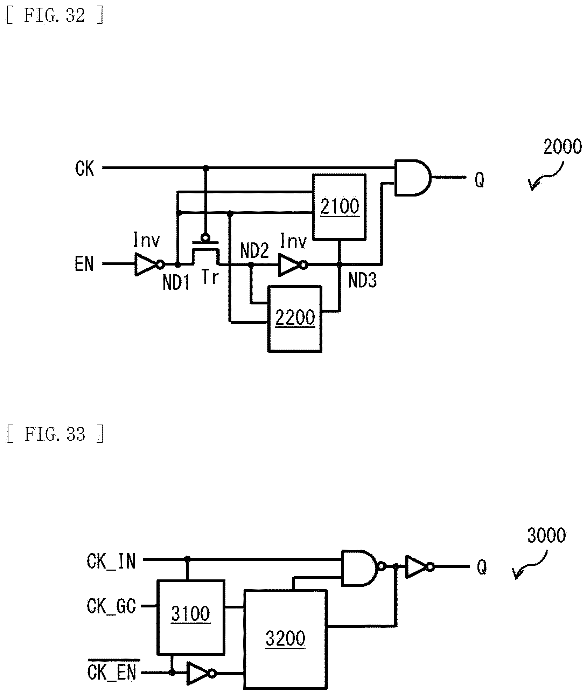

FIG. 32 illustrates an example of functional blocks of a clock gating cell 2000 according to a comparative example. The clock gating cell 2000 includes one inverter Inv, one NMOS transistor Tr, a high-level generation section 2100, a feedback control section 2200, and a NAND circuit.

The high-level generation section 2100 supplies the high level to the third node ND3 only when the inverted signal of the enable signal EN is at the low level and the clock signal CK is at the low level. The feedback control section 2200 has a function of inverting the level of the third node ND3 and feeding it back to the second node ND2 when the clock signal CK is at the high level.

The feedback control section 2200 provides the low level to the second node ND2 only in a case where the clock signal CK is in the high-level period and the level of the third node ND3 is at the high level. The feedback control section 2200 provides the high level to the second node ND2 regardless of the state of the clock signal CK in a case where the level of the third node ND3 is at the low level, and does not perform level transfer in other cases.

In the clock gating cell 2000, the "Vth drop" occurs at the second node ND2. Therefore, it is not resistant to process variation, and there is a concern that the operation may fail or a leakage current may increase.

FIG. 33 illustrates an example of functional blocks of a clock gating cell 3000 according to a comparative example. The clock gating cell 3000 is a circuit of a scheme in which the clock is stopped by self-gating. In this scheme, a control circuit 3100 for controlling the self-gating is required separately from a latch circuit 3200, resulting in an increase in circuit size.

### [Effects]

In the present embodiment, the latch circuit 320 includes the single phase clocking circuit including the NAND circuit. Using the single phase clocking circuit that does not use the inverted signal of the clock signal CK as described above makes it possible to suppress electric power dissipation corresponding to the toggling of the clock signal CK. In addition, the combined logic circuit 300 is also provided with the inverter INV53 (the output circuit 330) that inverts the output signal QN of the latch circuit 320. This makes it possible to form the AND circuit with the NAND circuit in the latch circuit 320 and the inverter INV53 (the output circuit 330). It is therefore possible to suppress circuit size, as compared with a case where the AND circuit is provided separately from the latch circuit 320.

In the present embodiment, the enable generation section 310 generates the control signal ten at the high level Hi and the control signal ten at the low level Lo when the enable signal E is at the low level Lo. In addition, the control signal ten at the low level Lo and the control signal ten at the high level Hi are generated when the enable signal E is at the high level Hi. Further, in the present embodiment, in the latch section 320, one input node of the data holding circuit 322 (the two-input NAND circuit) receives the clock signal CK from the outside, and the other input node of the data holding circuit 322 (the two-input NAND circuit) receives the internal signal Lat at the low level Lo when the enable signal E is set to the high level Hi while the clock signal CK is at the low level Lo. In this case, even if the clock signal CK toggles, the output signal QN of the data holding circuit 322 (the two-input NAND circuit) remains at the high level Hi. That is, it goes without saying that the clock signal CK does not propagate to the output signal QN when the enable signal E is at the low level Lo. Further, regardless of how much the clock signal CK toggles, no node to be charged and discharged is present other than the gate terminal of the transistor to which the clock signal CK is coupled. Accordingly, it is possible to suppress electric power dissipation corresponding to the toggling of the clock signal CK when the enable signal E is at the low level Lo.

In the present embodiment, the latch circuit 321a and the assist circuit 321b are provided. The latch circuit 321a latches the states of the control signals ten and tep. The assist circuit 321b supplies, to the data holding circuit 322, the signal corresponding to the state that does not cause the "Vth drop" to occur out of the states of the control signals ten and tep latched by the latch circuit 321a, as the internal signal Lat. This makes it possible to prevent malfunctioning from occurring in the output signal QN.

### <4. Modifications of Third Embodiment>

Next, a description is given of modifications of the clock gating cell 300 according to the third embodiment.

### [Modification R]

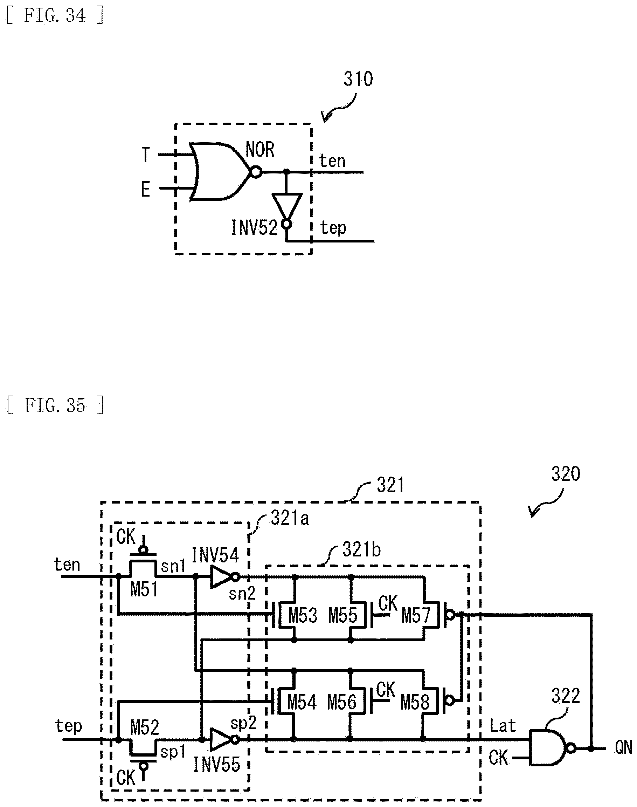

FIG. 34 illustrates a modification of the circuit configuration of the enable generation section 310. In the present modification, the enable generation section 310 includes a NOR circuit and an inverter INV52.

The NOR circuit receives the enable signal E and the enable signal T for testing as input signals. The NOR circuit outputs a NOR of the two input signals as the control signal ten. The inverter INV52 receives the output signal (the control signal ten) of the NOR circuit. The inverter INV52 outputs an inverted signal (the control signal tep) of the control signal ten. In such a case also, it is possible to achieve effects similar to those in the embodiment described above.

### [Modification S]

FIG. 35 illustrates a modification of the circuit configuration of the latch section 320. The present modification is a case where the enable signal T is the opposite in polarity, and is provided with a function of outputting the clock from the output signal Q when the enable signal T is at the low level Lo and stopping the clock when the enable signal T is at the high level Hi. In such a case also, it is possible to achieve effects similar to those in the embodiment described above.

### [Modification T]

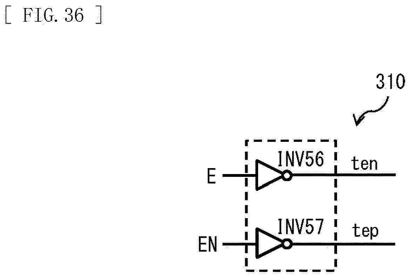

FIG. 36 illustrates a modification of the circuit configuration of the enable generation section 310. In the present modification, the enable generation section 310 includes two inverters INV56 and INV57. In the present modification, the enable signal E and the inverted signal (the enable signal EN) of the enable signal E are supplied to the enable generation section 310 as operating signals.

The inverter INV56 receives the enable signal E. The inverter INV56 outputs the inverted signal (the control signal ten) of the enable signal E. The inverter INV57 receives the inverted signal (the enable signal EN) of the enable signal E. The inverter INV57 outputs the inverted signal (the control signal tep) of the enable signal EN. In such a case also, it is possible to achieve effects similar to those in the embodiment described above.

Incidentally, the internal signal generation circuit 211 according to the second embodiment may have, for example, a configuration similar to that of the internal signal generation circuit 321 according to the third embodiment and the modifications thereof described above. In addition, the data holding section 212 according to the second embodiment may have, for example, a configuration similar to that of the data holding section 322 according to the third embodiment and the modifications thereof described above. The internal signal generation circuit 211 according to the second embodiment executes an operation similar to that of the internal signal generation circuit 311 according to the third embodiment and the modifications thereof described above. The data holding section 222 according to the second embodiment executes an operation similar to that of the data holding section 322 according to the third embodiment and the modifications thereof described above. It is to be noted that the data signal D is supplied in place of the enable signal ten, and the inverted signal of the data signal D is supplied in place of the enable signal tep.

Although the present disclosure has been described above with reference to the plurality of embodiments and the modifications thereof, the present disclosure is not limited to the embodiments and the like described above, and various modifications may be made. It is to be noted that the effects described herein are mere examples. The effects of the present disclosure are not limited to the effects described herein. The present disclosure may have effects other than the effects described herein.

In addition, it is to be noted that the present disclosure may have the following configurations, for example.
(1) A combined logic circuit including:
   a latch circuit including a single phase clocking circuit that includes a NAND circuit; and
   an inverter circuit that inverts an output signal of the latch circuit.
(2) The combined logic circuit according to (1), further including
   a signal generation circuit that generates a control signal at a high level when an enable signal supplied from an outside is at a low level, and generates the control signal at a low level when the enable signal is at a high level, in which
   the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.
(3) The combined logic circuit according to (1), further including
   a signal generation circuit that generates a control signal at a high level when both a first enable signal and a second enable signal are at low levels, and generates the control signal at a low level when any of the first enable signal and the second enable signal is at a high level, the first enable signal and the second enable signal being supplied from an outside, in which
   the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.
(4) The combined logic circuit according to (1) or (2), in which the single phase clocking circuit further includes a logic circuit that supplies a clock signal from an outside to one input node of the NAND circuit, and supplies a low level to another input node of the NAND circuit when an enable signal supplied from the outside is set to a high level while the clock signal is at a low level.
(5) The combined logic circuit according to (1), further including
   a signal generation circuit that generates a control signal at a high level when both a first enable signal and a second enable signal are at high levels, and generates the control signal at a low level when any of the first enable signal and the second enable signal is at a low level, the first enable signal and the second enable signal being supplied from an outside, in which
   the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.
(6) The combined logic circuit according to (2), in which
   the NAND circuit and the logic circuit are configured to include multiple transistors, and
   a first transistor included in the NAND circuit and a second transistor included in the logic circuit are configured to cause an output of the NAND circuit to transition from a high level to a low level before an output of the logic circuit transitions from a high level to a low level when the clock signal rises.
(7) The combined logic circuit according to (3), in which
   the NAND circuit and the logic circuit are configured to include multiple transistors, and
   a first transistor included in the NAND circuit and a second transistor included in the logic circuit are configured to cause an output of the NAND circuit to transition from a high level to a low level before an output of the logic circuit transitions from a high level to a low level when the clock signal rises.
(8) The combined logic circuit according to (4), in which
   the NAND circuit and the logic circuit are configured to include multiple transistors, and
   a first transistor included in the NAND circuit and a second transistor included in the logic circuit are configured to cause an output of the NAND circuit to transition from a high level to a low level before an output of the logic circuit transitions from a high level to a low level when the clock signal rises.
(9) The combined logic circuit according to (5), in which
   the NAND circuit and the logic circuit are configured to include multiple transistors, and
   a first transistor included in the NAND circuit and a second transistor included in the logic circuit are configured to cause an output of the NAND circuit to transition from a high level to a low level before an output of the logic circuit transitions from a high level to a low level when the clock signal rises.
(10) The combined logic circuit according to any one of (1) to (9), in which the single phase clocking circuit is configured to cause an output of the NAND circuit to transition from a high level to a low level before another input node of the NAND circuit transitions from a high level to a low level.
(11) The combined logic circuit according to any one of (1) to (10), in which the single phase clocking circuit includes two first transistors added to the NAND circuit, and achieves a clear operation by the two first transistors.
(12) The combined logic circuit according to any one of (1) to (11), in which the single phase clocking circuit includes two second transistors added to the NAND circuit, and achieves a set operation by the two second transistors.
(13) The combined logic circuit according to (1), in which
   the single phase clocking circuit further includes
   a latch section that latches states of an enable signal supplied from an outside and an inverted signal of the enable signal, and
   an input circuit that supplies a clock signal from the outside to one input node of the NAND circuit, and supplies, to another input node of the NAND circuit, a signal corresponding to any one of the states of the enable signal and the inverted signal that are latched by the latch section.

According to a combined logic circuit according to an aspect of the present disclosure, a latch circuit includes a single phase clocking circuit including a NAND circuit, and an inverter circuit that inverts an output signal of the latch circuit is provided. It is therefore possible to suppress circuit size while suppressing electric power dissipation corresponding to toggling of a clock. It is to be noted that the effects of the present disclosure are not necessarily limited to the effects described here and may be any of the effects described herein.

This application claims the priority on the basis of Japanese Patent Application No. 2020-183227 filed on October 30, 2020 with Japan Patent Office, the entire contents of which are incorporated in this application by reference.

It should be understood by those skilled in the art that various modifications, combinations, sub-combinations, and alterations may occur depending on design requirements and other factors insofar as they are within the scope of the appended claims or the equivalents thereof.

## Claims

1. A combined logic circuit comprising:
a latch circuit including a single phase clocking circuit that includes a NAND circuit; and
an inverter circuit that inverts an output signal of the latch circuit.

2. The combined logic circuit according to claim 1, further comprising
a signal generation circuit that generates a control signal at a high level when an enable signal supplied from an outside is at a low level, and generates the control signal at a low level when the enable signal is at a high level, wherein
the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.

3. The combined logic circuit according to claim 1, further comprising
a signal generation circuit that generates a control signal at a high level when both a first enable signal and a second enable signal are at low levels, and generates the control signal at a low level when any of the first enable signal and the second enable signal is at a high level, the first enable signal and the second enable signal being supplied from an outside, wherein
the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.

4. The combined logic circuit according to claim 1, wherein the single phase clocking circuit further includes a logic circuit that supplies a clock signal from an outside to one input node of the NAND circuit, and supplies a low level to another input node of the NAND circuit when an enable signal supplied from the outside is set to a high level while the clock signal is at a low level.

5. The combined logic circuit according to claim 1, further comprising
a signal generation circuit that generates a control signal at a high level when both a first enable signal and a second enable signal are at high levels, and generates the control signal at a low level when any of the first enable signal and the second enable signal is at a low level, the first enable signal and the second enable signal being supplied from an outside, wherein
the single phase clocking circuit further includes a logic circuit, the logic circuit supplying a clock signal from the outside to one input node of the NAND circuit, and supplying a low level to another input node of the NAND circuit when the control signal is set to the high level while the clock signal is at a low level.

6. The combined logic circuit according to claim 2, wherein
the NAND circuit and the logic circuit are configured to include multiple transistors, and
a first transistor included in the NAND circuit and a second transistor included in the logic circuit are configured to cause an output of the NAND circuit to transition from a high level to a low level before an output of the logic circuit transitions from a high level to a low level when the clock signal rises.

7. The combined logic circuit according to claim 3, wherein
the NAND circuit and the logic circuit are configured to include multiple transistors, and
a first transistor included in the NAND circuit and a second transistor included in the logic circuit are configured to cause an output of the NAND circuit to transition from a high level to a low level before an output of the logic circuit transitions from a high level to a low level when the clock signal rises.

8. The combined logic circuit according to claim 4, wherein
the NAND circuit and the logic circuit are configured to include multiple transistors, and
a first transistor included in the NAND circuit and a second transistor included in the logic circuit are configured to cause an output of the NAND circuit to transition from a high level to a low level before an output of the logic circuit transitions from a high level to a low level when the clock signal rises.

9. The combined logic circuit according to claim 5, wherein
the NAND circuit and the logic circuit are configured to include multiple transistors, and
a first transistor included in the NAND circuit and a second transistor included in the logic circuit are configured to cause an output of the NAND circuit to transition from a high level to a low level before an output of the logic circuit transitions from a high level to a low level when the clock signal rises.

10. The combined logic circuit according to claim 1, wherein the single phase clocking circuit is configured to cause an output of the NAND circuit to transition from a high level to a low level before another input node of the NAND circuit transitions from a high level to a low level.

11. The combined logic circuit according to claim 1, wherein the single phase clocking circuit includes two first transistors added to the NAND circuit, and achieves a clear operation by the two first transistors.

12. The combined logic circuit according to claim 1, wherein the single phase clocking circuit includes two second transistors added to the NAND circuit, and achieves a set operation by the two second transistors.

13. The combined logic circuit according to claim 1, wherein
the single phase clocking circuit further includes
a latch section that latches states of an enable signal supplied from an outside and an inverted signal of the enable signal, and
an input circuit that supplies a clock signal from the outside to one input node of the NAND circuit, and supplies, to another input node of the NAND circuit, a signal corresponding to any one of the states of the enable signal and the inverted signal that are latched by the latch section.
